(19) Europäisches Patentamt

European Patent Office

Office européen des brevets

(11) **EP 1 576 761 B1**

(12) **EUROPÄISCHE PATENTSCHRIFT**

(45) Veröffentlichungstag und Bekanntmachung des Hinweises auf die Patenterteilung:
**26.07.2006 Patentblatt 2006/30**

(21) Anmeldenummer: **03799504.0**

(22) Anmeldetag: **23.12.2003**

(51) Int Cl.:
*H04L 7/04* (2006.01) *H03L 7/085* (2006.01)

(86) Internationale Anmeldenummer:
**PCT/EP2003/014814**

(87) Internationale Veröffentlichungsnummer:
**WO 2004/059902 (15.07.2004 Gazette 2004/29)**

(54) **VERFAHREN UND VORRICHTUNG ZUM EXTRAHIEREN EINER EINEM DATENSTROM ZUGRUNDELIEGENDEN TAKTFREQUENZ**

METHOD AND DEVICE FOR EXTRACTING A CLOCK PULSE FREQUENCY UNDERLYING A DATA FLOW

PROCEDE ET DISPOSITIF POUR EXTRAIRE UNE FREQUENCE D'HORLOGE A LA BASE D'UN FLUX DE DONNEES

(84) Benannte Vertragsstaaten:
**DE FR**

(30) Priorität: **23.12.2002 DE 10260656**

(43) Veröffentlichungstag der Anmeldung:
**21.09.2005 Patentblatt 2005/38**

(60) Teilanmeldung:
**06000022.1 / 1 646 150**

(73) Patentinhaber: **Infineon Technologies AG
81669 München (DE)**

(72) Erfinder:
• **GRECO, Patrizia
A-9524 St. Magdalen (AT)**
• **STEINSCHADEN, Andreas
A-9587 Riegersdorf (AT)**
• **THALLER, Edwin
A-9583 Faak / See (AT)**
• **ZESSAR, Gernot
A-9531 Kreuth (AT)**

(74) Vertreter: **Schoppe, Fritz et al
Patentanwälte
Schoppe, Zimmermann, Stöckeler & Zinkler
Postfach 246
82043 Pullach bei München (DE)**

(56) Entgegenhaltungen:
**EP-A- 0 414 445 US-A- 4 320 391
US-A- 6 125 158 US-B1- 6 407 641**

**Beschreibung**

In der Datenübertragungstechnik besteht generell der Bedarf, einen Takt aus einem Datenstrom zu extrahieren. Ein Daten-übertragungsstandard, der in letzter Zeit starke Verbreitung erfahren hat, ist der USB-Standard (USB = Universal Serial Bus). Der USB-Standard standardisiert ein Datenübertragungsformat zur schnellen Datenübertragung zwischen USB-Geräten und einem Host. Der USB-Standard definiert eine sogenannte Tier-Star-Topologie, wobei USB-Geräte entweder Hubs oder Funktionen bzw. Funktionsgeräte sein können. Das USB-Datenformat ist in der USB-Spezifikation spezifiziert. Die aktuellste USB-Definition ist gerade USB-Revision 2.0.

Der USB-Bus ist ein Halb-Duplex-Bus. Alle Transaktionen werden von dem Host initiiert. In der USB-Spezifikation-Revision 2.0 sind drei Datenübertragungsraten definiert. Die niedrigste Datenübertragungsrate wird im Low-Speed-Modus verwendet, und beträgt 1,5 Megabit pro Sekunde. Im Full-Speed-Modus wird eine Datenübertragungsrate von 12 Megabit pro Sekunde verwendet. Im High-Speed-Modus wird eine Datenübertragungsrate von 480 Megabit pro Sekunde eingesetzt.

Die Verwendung des Low-Speed-Modus dient für interaktive Geräte, wie z. B. eine Tastatur oder eine Maus. Nur eine begrenzte Anzahl von Low-Speed-Geräten sollte mit dem Bus verbunden sein, um eine Degradation der Bus-Ausnutzung zu vermeiden. Für Full-Speed- und High-Speed-Geräte sind eine spezielle Bandbreite und Latenzzeit garantiert.

Geräte sind mit dem USB-Bus über ein 4-Draht-Kabel verbunden, das Differenzdaten, ein Leistungssignal und Masse trägt. Dies bedeutet, dass eine Ader des 4-Draht-Kabels ein positives Differenzsignal Dp trägt, dass eine weitere Ader des 4-Draht-Kabels ein negatives Differenzsignal Dn trägt, dass eine weitere Ader auf dem Versorgungspotential liegt und dass schließlich die letzte Ader auf dem Massepotential liegt. Die Taktinformationen sind in den Daten codiert. Gemäß der USB-Spezifikation wird eine NRZI-Codierung und eine Bit-Stuffing-Technik verwendet, um eine adäquate Anzahl von Übergängen zu garantieren. NRZI bedeutet No Return to Zero Invert. Dies bedeutet, dass eine inverse Codierung eingesetzt wird. Ein logisches "1"-Signal wird durch eine nicht vorhandene Änderung im elektrischen Signal dargestellt, während ein logisches "0"-Signal durch eine Änderung im Zustand des elektrischen Signals dargestellt wird. Eine Flanke stellt somit eine Null dar, während eine nichtvorhanden Änderung, also ein gleichbleibendes Signal eine Null darstellt. Ferner wird zur Gleichanteilsreduktion ein Bit-Stuffing eingesetzt, so dass nach sechs aufeinanderfolgenden Einsen eine positive/negative Flanke eingesetzt wird.

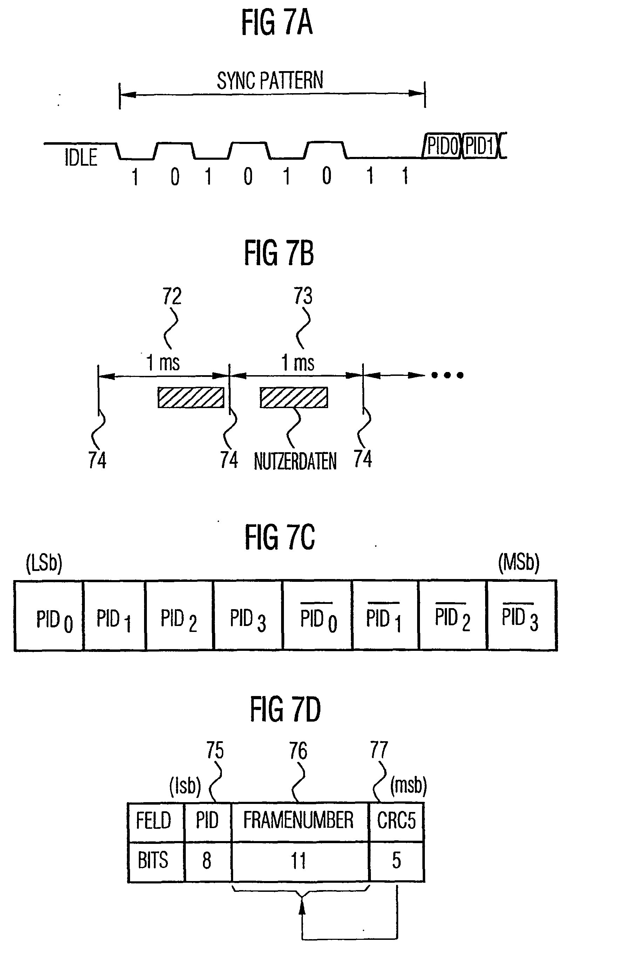

Wie es in Fig. 7b dargestellt ist, ist der Datenstrom als eine Folge von Rahmen oder Frames 72, 73 definiert, die durch sogenannte Kontrolhzeichen 74 voneinander getrennt sind, wobei die Ticks in einem Abstand von 1 ms auftreten. Innerhalb des Rahmens 72 oder 73 befindet sich eine Mehrzahl von Datenpaketen. Dies bedeutet, dass ein Rahmen aus mehreren Datenpaketen besteht, und dass sich ein Datenstrom aus einer Mehrzahl aufeinanderfolgender Rahmen zusammensetzt. Jedes Datenpaket wird im Datenstrom von einer Paketidentifikationsnummer eingeleitet, die eine Breite von 8 Bits hat und in Fig. 7c dargestellt ist. Ein Rahmen umfasst daher so viele Paketidentifikationsnummern (PID), wie Pakete in dem Rahmen vorhanden sind. Die in Fig. 7c dargestellte Spezifikation der Paket-identifikationsnummer, die vier Bits breit ist und in einem PID-Feld durch die vier PID-Bits $PID_0$, $PID_1$, $PID_2$, $PID_3$ und durch die entsprechend invertierten PID-Bits dargestellt ist, ist im USB-Standard festgelegt. Die Bits, die in Fig. 7c dargestellt sind, sind vom LSb bis zum MSb angeordnet. LSb steht für niederstwertiges Bit (Least Significant Bit), während MSb für höchstwertiges Bit (Most Significant Bit) steht.

Der Host überträgt ein Rahmenstart-Paket (SOF-Paket; SQF = Start of Frame) einmal pro Millisekunde, um die in Fig. 7b dargestellten Ticks 74 zu definieren. Das SOF-Paket ist in Fig. 7d dargestellt und umfasst ein SYNC-Feld (in Fig. 7d nicht dargestellt), ein SOF-PID-Feld 75, eine 11-Bit-Rahmennummer (76) (Frame Number) sowie ein CRC-Prüfsumme über das Feld 76, die in einem Feld 77 eingetragen ist. Die Rahmennummer 76 wird mit jedem zusätzlichen SOF-Paket um 1 inkrementiert.

In Fig. 7a ist das beispielsweise dem PID-Feld 75 von Fig. 7d vorausgehende Synchronisationsmuster (SYNC-Pattern) als elektrisches Signal dargestellt. Es besteht aus einer im USB-Standard spezifizierten Folge von Bits bzw. einem Datenmuster, das aufgrund der NRZI-Codierung als elektrisches Signal derart aussieht, wie es in Fig. 7a dargestellt ist. Die Folge von Datenbits beträgt 00000001, was zu der in Fig. 7a gezeigten "elektrischen" Folge 10101011 führt. Vor dem Synchronisationsdatenmuster ist ein mit Idle bezeichneter Bereich, der im Hinblick auf die Differenzsignale Dp und Dm eine Single-Ended-Zero (SE0) Codierung aufweist, wie es nachfolgend dargelegt wird. Diese SE0-Codierung der Dp- und Dm-Signale weist auf das Ende eines vorhergehenden Rahmens hin und weist ferner darauf hin, dass nunmehr ein neuer Rahmen folgt, der mit einem Synchronisationsfeld eingeleitet wird, dem unmittelbar, wie es in Fig. 7a gezeigt ist, die Paketidentifikationsnummer und im speziellen, wie es in Fig. 7c gezeigt ist, ein niederstwertiges Bit der PID gefolgt von dem nächsthöherwertigen Bit der PID etc. folgt.

Die in Fig. 7a gezeigte Notation illustriert, dass die Bits im Synchronisationsmuster festgelegt sind und das zugeordnete elektrische Signal die Folge von 10101011 haben kann, während die PID-Bits sowohl eine 0 als auch eine 1 je nach zu codierender Paketidentifikation haben können.

Jedes Low-Speed- oder Full-Speed-Datenpaket, das über den USB-Bus übertragen wird, startet also mit einem Synchronisationsmuster (Fig. 7a), dem die Paket-Identifikationsnummer (PID) folgt, die in Fig. 7c dargestellt ist, welche den Pakettyp definiert. Das Synchronisationsfeld umfasst eine Serie von 0-1-Übergängen auf dem Bus, um es einem Empfänger zu ermöglichen, sich auf den Bittakt zu synchronisieren.

Wie es in Fig. 7 dargestellt ist, ist ein Rahmenintervall von einer Millisekunde definiert. Der Host überträgt ein SOF-Paket (Rahmenstartpaket) einmal pro Millisekunde (Fig. 7b). Das SOF-Paket besteht aus einem Synchronisationsfeld, gefolgt von der SOF-PID, einer 11-Bit-Rahmennummer und einem CRC 5-Fingerabdruck (Fig. 7d). Die Rahmennummer wird mit jedem gesendeten SOF-Paket inkrementiert.

Wenn ein Gerät mit dem USB-Bus verbunden wird, findet eine Hochfahr-Sequenz statt. Am Ende dieser Sequenz wird das Gerät in einen Reset-Zustand getrieben. Nach dem Reset-Ereignis hat das Gerät eine Zeitdauer von 10 Millisekunden, um ein Reset-Recovery durchzuführen. Während dieser Zeit empfängt das Gerät SOF-Pakete.

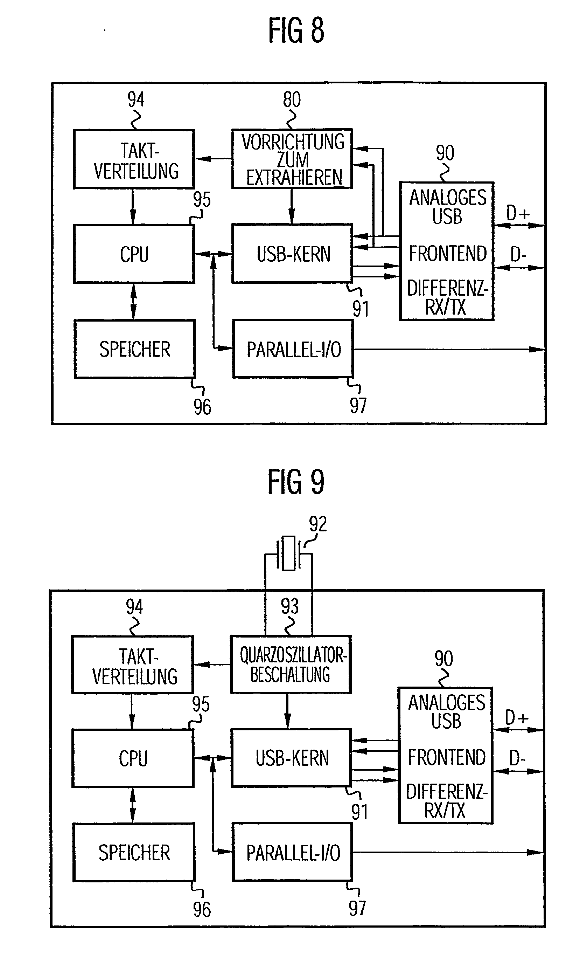

Ein herkömmliches USB-Gerät ist in Fig. 9 schematisch dargestellt. Es umfasst ein analoges USB-Frontend, das mit einem Differenz-Sender (TX) und einem Differenz-Empfänger (RX) in einer Funktionseinheit 90 integriert sein kann. An einer Seite des Elements 90 liegen die Signale Dp und Dm in analoger Form dar, während an einer anderen Seite des Elements 90 die entsprechenden empfangenen und analog/digital gewandelten Signale anliegen, die in einen USB-Kern 91 eingespeist werden bzw. von demselben empfangen werden. Diese Signale sind in Fig. 9 durch die zwei Paare von parallelen Signalpfeilen dargestellt. Das USB-Gerät umfasst ferner einen Quarzoszillator 92, der mit einer Quarzoszillatorbeschaltung 93 in Verbindung steht, wobei die Quarzoszillatorbeschaltung 93 einerseits den USB-Kern 91 und andererseits eine Taktverteilung 94 ansteuert, die mit einer CPU 95 verbünden ist, welche wiederum mit einem Speicher 96 in Wirkverbindung steht. Ferner umfasst ein USB-Gerät je nach Anwendung auch eine Parallel-Eingabe-Ausgabe-Schnittstelle (Parallel-I/O) 97.

Solche herkömmlichen USB-Geräte verwenden, wie es aus Fig. 9 ersichtlich ist, typischerweise einen Quarzoszillator 92 als Taktquelle für die Systemgeräte und die USB-Datenwiederherstellungsschaltung Für robuste tragbare Geräte, wie z. B. Chipkarten, würde es wünschenswert sein, dass sie ihren eigenen lokalen Takt direkt aus dem USB-Datenstrom extrahieren. Für solche Geräte ist die Verwendung von Quarzoszillatoren unpraktisch, da Quarze normalerweise nicht in einen Chip integriert werden können und ferner für eine Zerstörung aufgrund mechanischer Belastungen sehr anfällig sind. Chipkarten werden üblicherweise in rauen Umgebungen getragen, wie z. B. in einem Portemonnaie, das in einer Hosentasche untergebracht ist. Der dadurch ausgeübte mechanische Streß wäre für einen Schwingquarz fatal.

Daher wurden Takterzeugungsschaltungen für USB-Geräte im Low-Speed-Modus entwickelt, die keine Quarzoszillatoren benötigen.

Die US 2001/0011914 A1 offenbart eine Vorrichtung für die Wiedergewinnung eines Taktsignals aus zumindest zwei Synchronisationsbits. Als Referenztaktsignal wird ein Signal von einem inneren Oszillator verwendet, um die Anzahl von Referenztaktpulsen zwischen den ersten zwei Synchronisationspulsen zu messen, die von einem externen USB-Bus am Beginn jeder Transaktion gesendet werden. Damit wird eine Grobmessung N für das USB-Taktsignal, das regeneriert werden soll, erhalten. Die Verzögerung von jedem dieser zwei Synchronisationspulse bezüglich des vorhergehenden Pulses des Referenztaktsignals wird gemessen. Diese Verzögerung wird bezüglich einer intern definierten Zeiteinheit berechnet. Auf der Basis der Messung dieser zwei Verzögerungen und der Messung einer Anzahl von Referenztaktperioden.

Die US 2001/0020857 A1 offenbart eine Vorrichtung für die Regeneration eines Taktsignals aus einem externen seriellen Bus, wobei die Vorrichtung einen Ringoszillator und einen Zähler aufweist. Der Ringoszillator liefert n Phasen eines Taktsignals. Von diesen n-Phasen wird eine Phase als Referenz verwendet und an den Zähler angelegt. Es ist daher möglich, die Anzahl von gesamten Referenztaktsignalperioden zwischen einem ersten Puls und einem zweiten Puls, welche von dem Bus erhalten werden, zu zählen. Beim Lesen des Zustands der Phasen in dem Oszillator beim Empfang des zweiten Pulses wird eine aktuelle Phase bestimmt, die der Phasenverschiebung zwischen dem Referenztaktsignal und dem zweiten Puls des Busses entspricht. Unter Verwendung einer Regenerationsvorrichtung, die ebenfalls einen Ringoszillator und einen Zähler umfasst, ist es möglich, das Taktsignal auf dem Bus mit hoher Genauigkeit zu regenerieren.

Das U.S.-Patent Nr. 6,343,364 B1 offenbart ein Verfahren und eine Vorrichtung zur Lokaltakterzeugung unter Verwendung der USB-Signale Dp und Dm, das ohne Schwingquarz oder Resonator arbeitet. Hierzu wird eine Anzahl von Zyklen eines freilaufenden Hochfrequenztaktsignals gezählt, welche in einer bekannten Anzahl von Bitperioden des empfangenen Signals auftritt. Hierauf wird die gezählte Anzahl von Zyklen des freilaufenden Hochfrequenzsignals durch die bekannte Anzahl von Bitperioden geteilt, um eine resultierende Anzahl von Taktzyklen zu bestimmen, die in einer einzigen Bitdauer des empfangenen USB-Signals enthalten sind. Darauf aufbauend wird ein Lokaltaktsignal erzeugt.

Die WO 00/16255 offenbart ein Verfahren zur Datenübertragung und eine hierfür geeignete Smart Card. Die Signale Dp und Dm sind mit einer Schnittstelle der Karte verbunden. Die Karte umfasst ferner eine CPU, Speichereinheiten, USB-Ausgangskontakte sowie eine Anordnung von zumindest sechs Kontaktflächen, die mit der Oberfläche des Kartenkörpers eben sind.

Das U.S.-Patent Nr. 5,487,084 offenbart ein Konzept zum Erzeugen einer Taktfrequenz in einer Smart-Card-Schnittstelle, die zur Datenübertragung von einer Smart-Card zu beispielsweise einem Mobiltelephon verwendet wird, um eine vorbestimmte Datenrate zu erhalten. Eine Phasenregelschleife und eine Anzahl von programmierbaren Zählern wird eingesetzt, um ein Taktsignal mit einer Frequenz zu erhalten, die ein Vielfaches der Datenrate ist. Insbesondere können die Zähler und die Phasenregelschleife so gewählt werden, dass die Frequenz das 16-fache einer solchen Datenrate beträgt, um einen universellen asynchronen Empfänger/Sender (UART) einsetzen zu können.

Das U.S.-Patent Nr. 5,818,948 offenbart eine Architektur für ein USB-basiertes PC-Lautsprecher-Steuerungsgerät. Zur Wiedergewinnung eines Takts aus dem empfangenen Datenstrom wird eine Phasenregelschleife eingesetzt.

Das U.S.-Patent Nr. 6,061,802 offenbart eine Softwarebasierte Taktsynchronisation mit einer isochronen Master-Taktstruktur, in der die Rahmenratentakte einer Mehrzahl von Datenbussen auf ein Mastertaktsignal synchronisiert sind. Das Mastertaktsignal wird von den existierenden Taktsignalen innerhalb des Computersystems oder aus Daten, die von einer externen Quelle empfangen werden, abgeleitet.

Das U.S.-Patent Nr. 6,092,210 offenbart eine Vorrichtung und ein Verfahren zum Synchronisieren der Takte von verbundenen USB-Bussen, indem Takte in einem lokalen Gerät auf die Datenströme beider USB-Busse synchronisiert werden. Hierzu wird eine separate Lokaltaktsynchronisationsvorrichtung für jedes USB-Gerät eingesetzt, das mit dem betrachteten USB-Gerät verbunden ist. Jede getrennte Lokaltaktsynchronisation kann denselben Referenztakt verwenden.

Die DE 10041772 C2 offenbart einen Taktgenerator insbesondere für USB-Geräte, bei dem aufgrund eines periodisch im Datenstrom wiederkehrenden Synchronisationssignals ein Pulsfilter angesteuert wird, um eine Frequenz eines Pulszuges, der von einem internen Taktgenerator ausgegeben wird, durch Unterdrücken von Pulsen in der effektiven Frequenz zu reduzieren. Ferner wird unter Verwendung des Synchronisationssignals und eines in einem Pulszahlspeicher abgelegten Werts bzw. unter Verwendung eines Ausgangssignals eines Datensignaldecodierers eine von dem internen Taktgenerator erzeugte Frequenz nachgestimmt.

Übliche Taktwiedergewinnungssysteme, wie sie in den oben beschriebenen Referenzen dargestellt sind, verwenden das Synchronisationsmuster (Fig. 7a), das jedem USB-Datenpaket vorausgeht. Dies mag für Low-Speed-USB-Anwendungen hinsichtlich der Genauigkeit genügen. Für schnellere Anwendungen im USB-Full-Speed-Modus oder im USB-High-Modus ist die Genauigkeit des Synchronisationsmusters zu klein. Dies wird anhand der folgenden Zahlenbeispiele dargestellt. Für Full-Speed-USB-Geräte besteht die Anforderung dahingehend, dass der Sendetakt auf 0,25% (2500 ppm) genau sein muss. Aufgrund des großen Zeit-Jitters, das bei 12 ns für Paar-Übergänge (Paired Transitions) liegt bzw. bei 20 ns für aufeinanderfolgende Übergänge (Consecutive Transitions) liegt, das für die seriellen Bitdaten auf dem USB-Bus zugelassen ist, ist eine zuverlässige Taktwiedergewinnung allein aufgrund des Synchronisationsmusters nicht möglich.

Das US-Patent Nr. 6,407,641 B1 offenbart einen Auto-Locking-Oszillator für die Datenkommunikation. Zum Abstimmen der Oszillationsfrequenz eines Taktsignals wird die Frequenz eines ankommenden Datenstroms analysiert, um eines oder mehrere Steuersignale zu erzeugen, und wird die Oszillationsfrequenz entsprechend auf das eine oder die mehreren Signale eingestellt. Zwischen einem Datenstromanalysator und dem einzustellenden Oszillator sind eine Grobabstimmungseinrichtung und eine Feinabstimmungseinrichtung geschaltet.

Das US-Patent Nr. 6,125,158 offenbart eine Phasenregenschleife und einen Multistufen-Phasenkomparator. Der Komparator misst eine Phasendifferenz zwischen einem Referenzsignal und einem Ausgangssignal unter Verwendung eines periodischen Takts. Der Komparator ist ein Zwei-Stufen-Komparator mit einem Fein-Komparator und einem Grob-Komparator. Der Grob-Komparator misst die Anzahl von Taktperioden zwischen den Übergängen des Referenzsignals und des Ausgangssignals. Der Fein-Komparator umfasst einen Verzögerungsleitungs-Generator der eine Mehrzahl von verzögerten Takten erzeugt. Diese werden dann verwendet, um das Referenzsignal abzutasten, um eine Fein-Phasendifferenz zwischen Übergängen des Referenzsignals und des Ausgangssignals zu bestimmen.

Die EP 0414445 A2 offenbart einen digitalen Frequenzsynthesizer mit einem Phasenakkumulator, der einen Grob-Komponentenakkumulator und einen Fein-Komponenten-Akkumulator zusammen mit einer Dithering-Schaltung umfasst. Der Fein-Komponenten-Akkumulator steuert den Grob-Komponenten-Akkumulator, der wiederum einen nichtlinearen DAW speist.

Die Aufgabe der vorliegenden Erfindung besteht darin, ein einerseits wirtschaftliches und andererseits genaues Konzept zum Extrahieren einer einem Datenstrom zugrundeliegenden Taktfrequenz zu schaffen.

Diese Aufgabe wird durch eine Vorrichtung gemäß Patentanspruch 1 oder ein Verfahren gemäß Patentanspruch 32 oder ein Computer-Programm gemäß Patentanspruch 33 gelöst.

Der vorliegenden Erfindung liegt die Erkenntnis zugrunde, dass auch für schnellere USB-Modi das Synchronisationsfeld alleine bzw. die Zeitdauer des Synchronisationsfelds wenigstens ausreichend ist, um eine Grobeinstellung eines in Grenzen freilaufenden Oszillators zu erreichen. Die damit erreichbare Genauigkeit für die Einstellung des freilaufenden Oszillators ist jedoch viel zu gering, um eine sinnvolle Datenextraktion durchzuführen. Sie ist jedoch bereits ausreichend genau, um mit einer Grob-Datenwiedergewinnung zu starten, um das Paketidentifikationsfeld, das auf das Synchronisationsfeld folgt, zu decodieren. Erfindungsgemäß wird die Anzahl von Taktperioden des freilaufenden Oszillators zwischen zwei zeitlich aufeinanderfolgenden Paketidentifikationsfeldern gezählt und mit einem vorbestimmten Referenzwert verglichen.

Die vorliegende Erfindung basiert somit darauf, dass, obgleich ein Zeit-Jitter für aufeinanderfolgende USB-Takte von 12 ns bzw. 20 ns zugelassen ist, die Genauigkeit für ein Rahmenintervall, also für den Abstand zwischen zwei aufeinanderfolgenden Rahmenstart-Paketidentifikationen prozentual gesehen wesentlich enger vorgegeben ist. So ist beim USB-Standard ein Rahmenintervall auf 1 ms $\pm500$ ns definiert. Dies entspricht einer relativen Genauigkeit von 0,05%. Erfindungsgemäß wird daher die mit hoher relativer Genauigkeit vorliegende Rahmenperiode verwendet, um eine Feineinstellung des Taktwiedergewinnungsoszillators zu erreichen.

An dieser Stelle sei darauf hingewiesen, dass die Feinabstimmung auf der Basis der Rahmenperiode, also dem ersten Datenmuster bei einem bevorzugten Ausführungsbeispiel erst erfolgt, nachdem die Grobabstimmung auf der Basis des Synchronisationsfelds stattgefunden hat, da bei dem bevorzugten Ausführungsbeispiel eine Rahmenidentifikationsnummerndecodierung gut funktioniert, nachdem eine Grobabstimmung stattgefunden hat.

Das erfindungsgemäße Konzept ist dahingehend vorteilhaft, dass eine zweischrittige Vorgehensweise angewandt wird, bei der die Feinabstimmung auf der Grobabstimmung aufbaut und damit ohne externe Schwingquarze oder aufwendige nichtintegrierbare Resonatoren eine Taktwiedergewinnung auch für Geräte ermöglicht, die mit schnellen Datenraten arbeiten, wie z. B. dem USB-High-Speed-Modus oder USB-Full-Speed-Modus.

Das erfindungsgemäße Konzept ist ferner dahingehend vorteilhaft, dass der Einsatz einfacher und damit robust arbeitender Algorithmen möglich ist, so dass eine einfache und gleichzeitig robuste Implementierung z. B. auf tragbaren Geräten wie Chipkarten etc. möglich ist, die auch hinsichtlich der Rechenleistung und hinsichtlich des Speicherbedarfs per se begrenzt sind.

Erfindungsgemäß wird somit auf der Basis eines in dem Datenstrom vorhandenen zweiten Datenmusters, das vorzugsweise einfach detektierbar ist, eine Grobabstimmung vorgenommen, und wird auf der Basis von in dem Datenstrom wiederkehrenden ersten Datenmustern eine Feinabstimmung durchgeführt, wobei die wiederkehrenden ersten Datenmuster mit hoher Genauigkeit vorliegen, jedoch nicht derart einfach detektierbar sind wie ein zweites Datenmuster. Damit wird eine Taktwiedergewinnung mit der hohen Genauigkeit, die dem wiederkehrenden ersten Datenmuster in dem Datenstrom zugrunde liegt, erreicht, zu dessen Detektion jedoch eine Grobabstimmung des Oszillators auf der Basis des zwar einfach detektierbaren jedoch ungenau vorliegenden zweiten Datenmusters verwendet wird.

Das zweistufige erfindungsgemäße Konzept erlaubt es, eine einerseits schnelle und andererseits genaue Frequenzeinstellung zu erreichen. Für USB-Anwendungen existiert nur eine Start-Up-Zeit von etwa 10 ms, in der ein neuer Kommunikationsteilnehmer bereit sein muss. Ist er in dieser Zeit nicht bereit, so gibt es ein Fehlersignal. Nur aufgrund der Feinabstimmung reicht diese Zeit normalerweise nicht aus, da es nur 10 aufeinanderfolgende SOF-PIDs in den 10 ms Stärtup-Zeit gibt.

Andererseits ist die Grobabstimmung allein zwar schnell, aber zu ungenau, da das Synchronisationsmuster zu ungenau im Datenstrom ist.

Erfindungsgemäß wird daher die Grobabstimmung z. B. mit dem ersten Synchronisationsmuster durchgeführt, so dass in der Startup-Zeit von 10 ms noch genug aufeinanderfolgende Ereignisse im Datenstrom (z. B. SOF-PIDs) verbleiben, dass eine sichere und genau Abstimmung des nunmehr grob abgestimmten Oszillators erreicht wird.

Bevorzugte Ausführungsbeispiele der vorliegenden Erfindung werden nachfolgend Bezug nehmend auf die beiliegenden Zeichnungen detailliert erläutert. Es zeigen:

Fig. 1      ein Blockdiagramm einer erfindungsgemäßen Vorrichtung zum Extrahieren einer einem Datenstrom zugrundeliegenden Taktfrequenz;

Fig. 2      ein detailliertes Blockdiagramm der Grobabstimmungseinrichtung von Fig. 1;

Fig. 3      ein detailliertes Blockdiagramm der Feinabstimmungseinrichtung von Fig. 3;

Fig. 4      ein Blockschaltbild des Konzepts zum iterativen Grob- bzw. Feinabstimmen gemäß einem bevorzugten Ausführungsbeispiel der vorliegenden Erfindung;

Fig. 5      ein Blockschaltbild einer erfindungsgemäßen Vorrichtung zum Extrahieren gemäß einem bevorzugten Ausführungsbeispiel der vorliegenden Erfindung;

Fig. 6      ein Flußdiagramm zur Erläuterung des bei dem in Fig. 5 dargestellten Ausführungsbeispiels verwendeten Iterationsverfahrens;

Fig. 7a      einen Ausschnitt des Datenstroms mit Synchronisationsmuster und nachfolgendem PID-Muster;

Fig. 7b      eine Darstellung der Organisation des Datenstroms in Frames;

Fig. 7c    eine Darstellung der in dem Datenstrom enthaltenen PID gemäß dem USB-Standard;

Fig. 7d    eine Darstellung der Rahmenstart-PID gemäß dem USB-Standard;

Fig. 8    ein Blockschaltbild eines USB-Geräts mit einer erfindungsgemäßen Vorrichtung zum Extrahieren; und

Fig. 9    ein Blockschaltbild eines USB-Geräts mit einem externen Quarzoszillator.

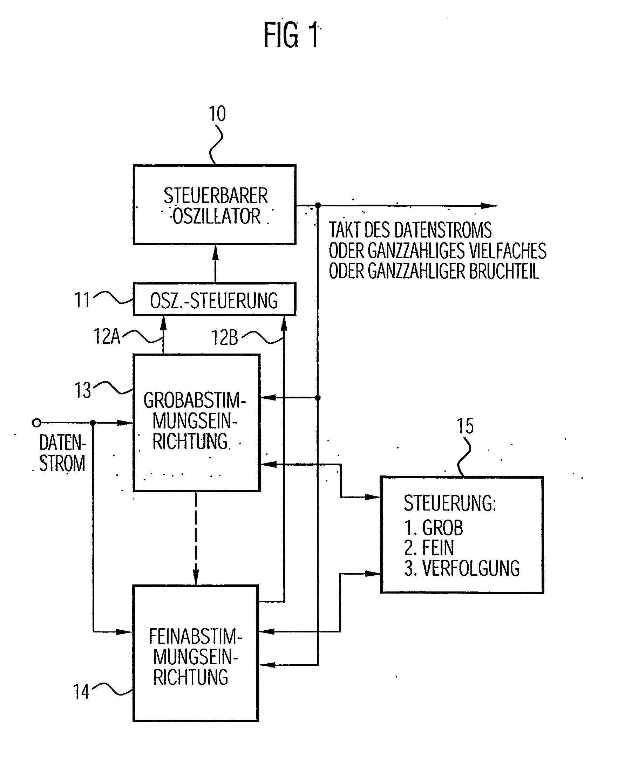

Fig. 1 zeigt eine Vorrichtung zum Extrahieren einer einem Datenstrom zugrundeliegenden Taktfrequenz, wobei der Datenstrom in regelmäßigen, mit einer relativen ersten Genauigkeit spezifizierten ersten zeitlichen Abständen, wie z. B. 1 ms bei einer Anwendung für einen USB-Datenstrom, ein erstes Datenmuster, wie z. B. eine Rahmenstart-Paketidentifikationsnummer (SOF-PID) aufweist, und wobei der Datenstrom ferner ein zweites Datenmuster (Synchronisations-Feld) aufweist, das eine Mehrzahl von Taktperioden gemäß der Taktfrequenz oder einem Vielfachen der Taktfrequenz aufweist, wobei die Taktperioden mit einer zweiten relativen Genauigkeit spezifiziert sind, die kleiner als die erste relative Genauigkeit ist.

Die erfindungsgemäße Vorrichtung ist ausgebildet, um einen steuerbaren Oszillator 10 anzusteuern, d. h. um eine Oszillator-Steuerung 11 mit Grobabstimmungssignalen auf einer Leitung 12a oder Feinabstimmungssignalen auf einer Leitung 12b zu beliefern, derart, dass die Oszillatorsteuerung 11 dem steuerbaren Oszillator 10 je nach Ausführung des steuerbaren Oszillators ein entsprechendes Spannungssignal im Falle eines VCO oder ein entsprechendes Stromsignal im Falle eines ICO zuführen kann.

Die erfindungsgemäße Vorrichtung umfasst eine Grobabstimmungseinrichtung 13 und eine Feinabstimmungseinrichtung 14. Die Grobabstimmungseinrichtung ist ausgebildet, um einen Beginn und ein Ende des zweiten Datenmusters (Synchronisationsfeld am Beispiel der USB-Spezifikation) zu detektieren. Die Grobabstimmungseinrichtung ist ferner ausgebildet, um eine Anzahl von Taktperioden des steuerbaren Oszillators 10 in einer Zeitdauer von dem Beginn zu dem Ende des zweiten'Datenmusters zu zählen. Darüber hinaus ist die Grobabstimmungseinrichtung ausgebildet, um in dem Fall, in dem die gezählte Anzahl größer als ein Referenzwert ist, die Einrichtung 11 zur Oszillatorsteuerung anzusteuern, um die Oszillatortaktfrequenz des steuerbaren Oszillators 10 zu verringern, oder in dem Fall, in dem die gezählte Anzahl kleiner als der Referenzwert ist, den steuerbaren Oszillator anzusteuern, um dessen Oszillatortaktfrequenz zu erhöhen.

Analog hierzu ist die Feinabstimmungseinrichtung 14 ausgebildet. Im Unterschied zur Grobabstimmungseinrichtung detektiert sie jedoch nicht den Beginn und das Ende des zweiten Datenmusters sondern das Auftreten eines ersten Datenmusters im Datenstrom und ein zeitlich folgendes Auftreten des ersten Datenmusters im Datenstrom. Die Feinabstimmungseinrichtung ist ferner ausgebildet, um die Anzahl von Taktperioden des Oszillators 10 von einem Auftreten des ersten Datenmusters bis zu einem nächsten Auftreten des ersten Datenmusters zu zählen, um dann je nach Lage des gezählten Werts bezüglich eines eingestellten Referenzwerts die Oszillatorsteuerungseinrichtung 11 anzusteuern, damit die Schwingfrequenz des steuerbaren Oszillators 10 erhöht bzw. erniedrigt wird. Nur in glücklichen Einzelfällen ist der Oszillator bereits aufgrund der Grobabstimmung richtig eingestellt.

Dadurch wird eine Oszillatortaktfrequenz mit der relativen zweiten Genauigkeit, also der Genauigkeit, die dem ersten Datenmuster zugrunde liegt, erhalten, die, je nach spezifischer Ausführung, unmittelbar gleich dem Takt ist, der dem Datenstrom zugrunde liegt, oder gleich einem Vielfachen des Takts ist, der dem Datenstrom zugrunde liegt, oder gleich einem Bruchteil des Takts ist, der dem Datenstrom zugrunde liegt. Insbesondere werden ganzzahlige Vielfache, wie z. B. das Zweifache, Dreifache, .... n-fache bevorzugt, wobei n eine ganze Zahl ist. Bezüglich der Bruchteile werden ebenfalls ganzzahlige Bruchteil bevorzugt, wie z. B. 1/2, 1/3, 1/4, ...., 1/n, wobei n ebenfalls eine ganze Zahl ist.

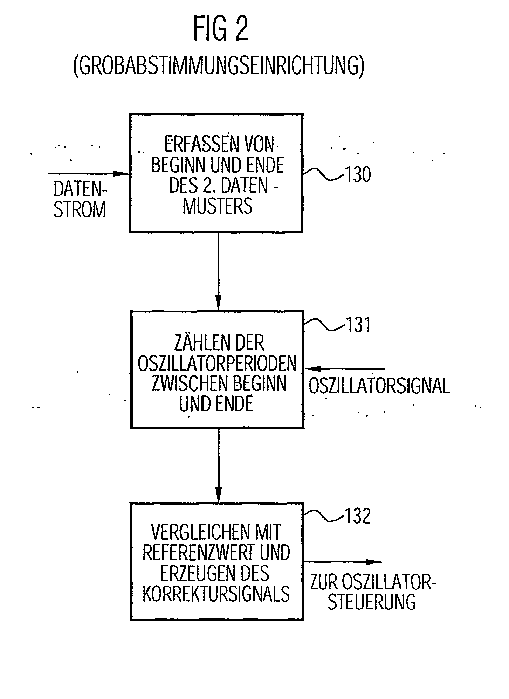

Fig. 2 zeigt ein detaillierteres Blockdiagramm der Grobabstimmungseinrichtung von Fig. 1. Im einzelnen umfasst die Grobabstimmungseinrichtung 13 von Fig. 1 eine Einrichtung 130 zum Erfassen des Beginns und des Endes des zweiten Datenmusters im Datenstrom, also am Beispiel des USB-Datenstroms z. B. den Beginn des Synchronisationsmusters in Form der ersten elektrischen "1" und das Ende des Synchronisationsmusters in Form der letzten elektrischen "1" des Synchronisationsmusters von Fig. 7a. In Ausführungsform und Implementation kann jedoch auch nur ein Teil des Synchronisationsmusters von Fig. 7a als zweites Datenmuster verwendet werden, so dass das zweite Datenmuster, das zu Grobabstimmungszwecken verwendet wird, mit der ersten elektrischen "1" beginnt und mit der siebenten logischen "0" endet, derart, dass nur der alternierende Teil des Synchronisationsmusters von Fig. 7a verwendet wird. Wieder alternativ könnte auch lediglich abhängig von dem Verhältnis der Frequenz des steuerbaren Oszillators zu dem in Fig. 7a verwendeten Bittakt auch nur ein Teil des alternierenden Bitmusters eingesetzt werden.

Ansprechend auf die Einrichtung 130 wird eine Einrichtung 131 zum Zählen der Oszillatorperioden zwischen dem von der Einrichtung 130 erfassten Beginn und dem von der Einrichtung 130 erfassten Ende betrieben. Im einzelnen wird durch ein Zähleraktivierungssignal, das die Einrichtung 130 ausgibt, wenn sie den Beginn des zweiten Datenmusters detektiert hat, ein Zähler gestartet, der die Taktperioden des der Einrichtung 131 zugeführten Oszillatorsignals so lange zählt, bis von der Einrichtung 130 das Ende erfasst wird oder entsprechend das Zähler-Stop-Signal von der Einrichtung 130 zu der Einrichtung 131 übermittelt wird.

Der Zählerstand kann dann von der Einrichtung 131 einer Einrichtung 132 zugeführt werden, die ausgebildet ist, um den Zählerstand mit einem Referenzwert zu vergleichen, und um ein entsprechendes Korrektursignal zu liefern, das zur Oszillatorsteuerung (Einrichtung 11 von Fig. 1) übermittelt wird. Der von der Einrichtung 132 verwendete Referenzwert hängt von einer Nennfrequenz des Oszillators 10 und einer zeitlichen Dauer bzw. Anzahl von betrachteten Bits des in Fig. 7a dargestellten Synchronisationsmusters oder eines Teils desselben ab. Beträgt der Bittakt des Synchronisationsmusters in Fig. 7a z. B. 12 Megabit pro Sekunde im Full-Speed-USB-Modus, und liegt die Nennfrequenz des steuerbaren Oszillators beispielsweise bei 96 MHz, also dem achtfachen des Full-Speed-USB-Takts, und wird das gesamte Synchronisationsfeld, also die 8 Bittakte zur Grobabstimmung verwendet, so wird in diesem Fall der vorbestimmte Referenzwert gleich 64 sein. Dies bedeutet, dass im Falle einer optimalen Oszillatoreinstellung der steuerbare Oszillator 10 während der Dauer des Synchronisationsmusters von Fig. 7a 64 Takte liefern müsste. Liefert er weniger als 64 Takte, so ist er zu langsam. Liefert er dagegen mehr als 64 Takte, so ist zu schnell.

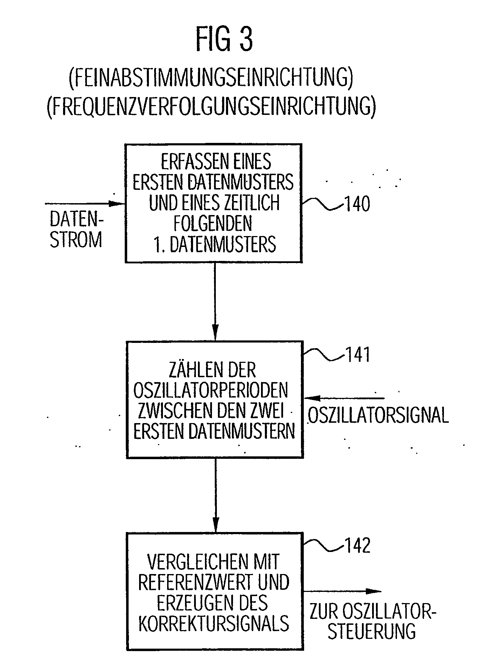

Fig. 3 zeigt ein detaillierteres Blockdiagramm der Feinabstimmungseinrichtung 14 von Fig. 1. Die Feinabstimmungseinrichtung 14 von Fig. 1 umfasst eine Einrichtung 140 zum Erfassen eines ersten Datenmusters (einer SOF-PID am Beispiel des USB-Formats) und eines zeitlich folgenden ersten Datenmusters. Beim Erfassen eines ersten Datenmusters wird ein Zähler in einer Einrichtung 141 zum Zählen der Oszillatorperioden bei einem ersten Datenmuster aktiviert, der dann, wenn ein zeitlich folgendes erstes Datenmuster detektiert worden ist, wieder angehalten wird. Der Zähler in der Einrichtung 141 ist wirksam, um die Taktperioden des steuerbaren Oszillators 10 von Fig. 1 zu zählen. Der Zählwert wird dann einer Einrichtung 142 zugeführt, die ausgebildet ist, um diesen Zählwert mit einem Referenzwert zu vergleichen und das Korrektursignal zu erzeugen, das der Oszillatorsteuerung 11 von Fig. 1 zugeführt wird.

Am Beispiel eines USB-spezifizierten Datenstroms ist der zeitliche Abstand zwischen zwei aufeinanderfolgenden ersten Datenmustern 1 ms, wie es in Fig. 7b gezeigt ist. Beträgt die Nennfrequenz des steuerbaren Oszillators 10 von Fig. 1 wieder 96 MHz, so wäre in diesem Fall der vorbestimmte Referenzwert 96.000, d. h. es müssten 96.000 Oszillatorzyklen in dem Zeitraum von 1 Millisekunde auftreten, damit der Oszillator korrekt eingestellt ist. Ist der Zählwert größer als 96.000, so muss die Oszillatorfrequenz reduziert werden. Ist der Zählwert dagegen kleiner als 96.000, so muss die Oszillatorfrequenz erhöht werden.

Die in Fig. 3 gezeigte Feinabstimmungseinrichtung kann ferner als Frequenzverfolgungseinrichtung eingesetzt werden, nachdem sowohl die Grobabstimmung als auch die Feinabstimmung beendet sind und die Genauigkeit bzw. die Frequenzfolgefähigkeit des Oszillators weiter gesteigert werden soll, wie es nachfolgend noch erläutert wird.

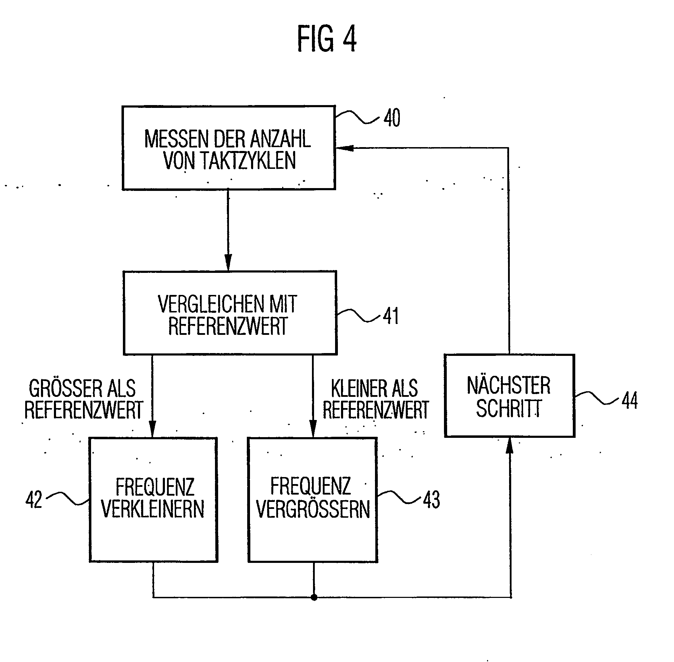

Die Einrichtungen 132 von Fig. 2 bzw. 142 von Fig. 3 sind vorzugsweise ausgebildet, um iterativ zu arbeiten, wie es anhand von Fig. 4 nachfolgend erläutert wird. Die iterative Vorgehensweise besteht darin, zunächst die Anzahl der Taktzyklen durch die Einrichtungen 130 bzw. 140 zu messen (40), um die gemessene Anzahl dann mit einem Referenzwert zu vergleichen (41). Ist das Vergleichsergebnis dahingehend, dass die Anzahl von Taktzyklen größer als der Referenzwert ist, so wird die Frequenz verkleinert (42) Wird dagegen festgestellt, dass die gemessene Anzahl von Taktzyklen kleiner als der Referenzwert ist, so muss die Frequenz des Oszillators vergrößert werden (43). Dann wird eine Iterationsvariable inkrementiert bzw. wird in einen nächsten Schritt 44 eingetreten, in dem nunmehr wieder überprüft wird, ob die im letzten Wert vergrößerte oder verkleinerte Frequenz wiederum zu hoch oder zu niedrig ist.

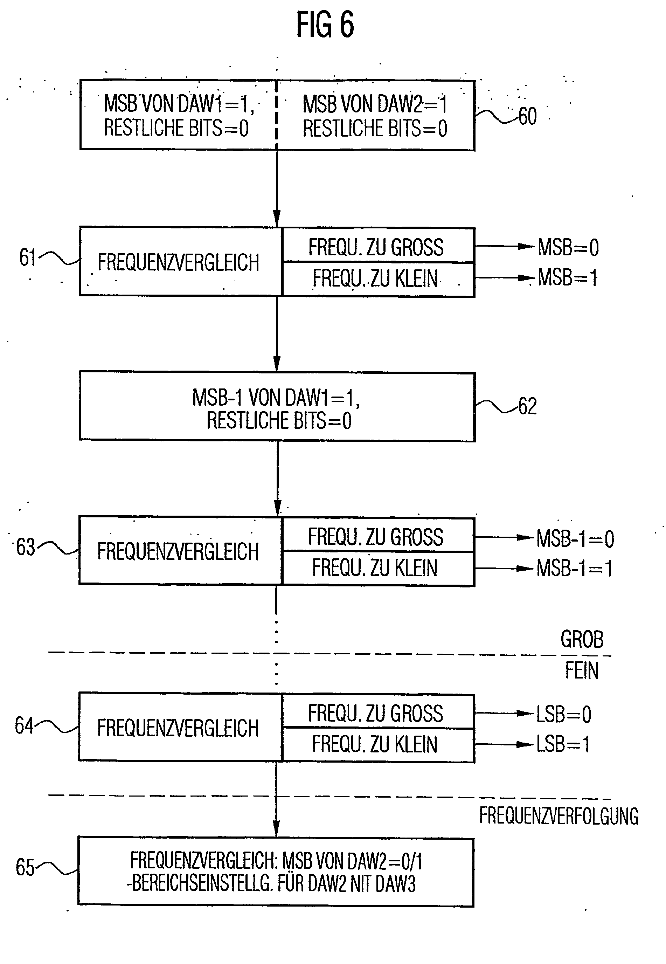

Als Iterationsstrategie bzw. als Inkrementwert, mit dem die Frequenz in einem Schritt zum nächsten erhöht bzw. erniedrigt wird, können verschiedene Strategien eingesetzt werden. Erfindungsgemäß wird es bevorzugt, ein Konzept einzusetzen, bei dem der Inkrementbetrag, um den die Frequenz von einem Schritt zum nächsten verändert wird, also erhöht bzw. erniedrigt wird, sich von Schritt zu Schritt verändert und insbesondere sich von Schritt zu Schritt verkleinert. Hierzu wird es bevorzugt, ein Verfahren der sukzessiven Approximation einzusetzen, das später anhand der Fig. 6 näher erläutert wird.

Bei dem bevorzugten Ausführungsbeispiel der vorliegenden Erfindung wird das 1 ms-Rahmenintervall zum Einstellen der Frequenz des freilaufenden Oszillators eingesetzt. Innerhalb von 10 Rahmenintervallen ist die Frequenzgenauigkeit des Oszillators innerhalb des spezifizierten Bereichs von 0,25%.

Hierzu wird, wie es ausgeführt worden ist, eine Abstimmung des Oszillators in zwei Abschnitten durchgeführt, nämlich zunächst in einem Grobabstimmungsabschnitt und dann in einem

Feinabstimmungsabschnitt.

Für die Grobeinstellung wird die Anzahl von Oszillatorperioden zwischen einer bestimmten Anzahl von SYNC-Feld-Bits gezählt und mit einem Referenzwert verglichen. Wenn der Zählerwert größer als der Referenzwert ist, ist die Oszillatorfrequenz zu hoch und wird verringert. Ist dagegen der Zählerwert kleiner als der Referenzwert, so ist die Oszillatorfrequenz zu niedrig und wird erhöht. Wenn die Anzahl von Grobabstimmungsschritten gleich C beträgt, wenn der Referenzwert mit CR bezeichnet ist und wenn der Zählerwert mit CC bezeichnet wird, und wenn schließlich die Frequenz des Oszillators $\nu$ beträgt, so kann der Grobabstimmungsalgorithmus folgendermaßen allgemein dargestellt werden:

    1. Bestimmen von $CC_C(\nu_{C-1})$

2.

$$CC_C > CR : \nu_C = \nu_{C-1} - \Delta\nu_C$$

$$CC_C < CR : \nu_C = \nu_{C-1} + \Delta\nu_C \text{ usw.}$$

3. Bestimmen von $CC_{C+1}(\nu_C)$

Nach einer bestimmten kleinen Anzahl von Grobabstimmungsschritten kann die Messung auf der Basis von SYNC-Bits die Genauigkeit der Oszillatorfrequenz nicht weiter verbessern. Nun beginnt die Feinabstimmung.

Zur Feinabstimmung wird die Anzahl von Oszillatorperioden zwischen SOF-Paketen gezählt, und es wird ein Algorithmus, der ähnlich dem Grobabstimmungsalgorithmus ist, eingesetzt. Wenn die Feinabstimmungs-Schritt-Nummer F beträgt, der Referenzwert FR beträgt, der Zählerwert FC beträgt und die Frequenz des Oszillators wieder $\nu$ ist, ergibt sich der Feinabstimmungsalgorithmus folgendermaßen:

(a) Bestimmen von $FC_F(\nu_{F-1})$
(b)

$$FC_F > FR : \nu_F = \nu_{F-1} - \Delta\nu_F$$

$$FC_F < FR : \nu_F = \nu_{F-1} + \Delta\nu_F \text{ usw.}$$

(c) Bestimmen von $FC_{F+1}(\nu_F)$

Da die Zeit zwischen aufeinanderfolgenden SOF-Paketen auf $\pm 500$ ns genau ist, wird eine Genauigkeit der eingestellten Frequenz von 0,05% (500 ppm) erreicht.

Die Frequenz des Oszillators nach der Abstimmung desselben wird durch den Referenzwert FR.bestimmt. Wenn die erwünschte Oszillatorfrequenz beispielsweise 96 MHz beträgt, muss der Referenzwert FR gleich 96.000 sein, wenn aufeinanderfolgende SOF-Pakete betrachtet werden. Werden nicht unmittelbar aufeinanderfolgende SOF-Pakete betrachtet, sondern z. B. zweifach, bzw. dreifach aufeinanderfolgende SOF-Pakete, so ist der Referenzwert entsprechend höher. Im Falle von Halben, Dritteln, Vierteln, ... der Periodendauer zwischen SOF-Paketen ist der Referenzwert entsprechend niedriger.

Wie es bereits anhand der Fig. 3 dargestellt worden ist, findet nach der Feinabstimmung bei einem bevorzugten Ausführungsbeispiel der vorliegenden Erfindung ein Frequenzverfolgungsalgorithmus statt, der die Oszillatorfrequenz weiter einstellt. Wie im Feinabstimmungsalgorithmus wird die Anzahl von Oszillatorperioden zwischen im Datenstrom vorhandenen SOF-Paketen gemessen.

Der Oszillatortakt, der nach der Grobabstimmung und nach der Feinabstimmung erhalten wird, kann beispielsweise als Referenztakt für einen USB-Kern verwendet werden. Hierzu wird auf Fig. 8 verwiesen, in der die erfindungsgemäße Vorrichtung zum Extrahieren, die mit 80 bezeichnet ist, dargestellt ist. Die erfindungsgemäße Vorrichtung zum Extrahieren besitzt daher zusammen mit einem steuerbaren Oszillator die Funktionalität der Blöcke 92 und 93 der bekannten USB-Funktionsschaltung, die anhand von Fig. 9 erläutert worden ist.

Es sei darauf hingewiesen, dass ein Phasen-Locking zwischen dem Oszillatortakt und dem Bittakt des USB-Datenstroms nicht nötig ist, da die Oszillatortaktfrequenz üblicherweise ein Vielfaches der Bittaktfrequenz ist und ein Oversampling und digitale PLLs zur Datenwiedergewinnung verwendet werden können.

Die erfindungsgemäße Vorrichtung ist dahingehend vorteilhaft, dass für Datenströme, denen ein schneller Takt zugrunde liegt, wie z. B. für Full-Speed-USB-Datenströme und High-Speed-USB-Datenströme, kein Quarzoszillator benötigt wird. Natürlich werden auch für langsamer getaktete Datenströme keine externen Oszillatoren benötigt.

Die erfindungsgemäße Vorrichtung ist ferner dahingehend vorteilhaft, da die regenerierte Frequenz mit hoher Genauigkeit erhalten wird, die durch die Genauigkeit bestimmt ist, mit der das erste Datenmuster im Datenstrom vorhanden ist. Am Beispiel der USB-Anwendung wird eine Genauigkeit von 0,05% erreicht.

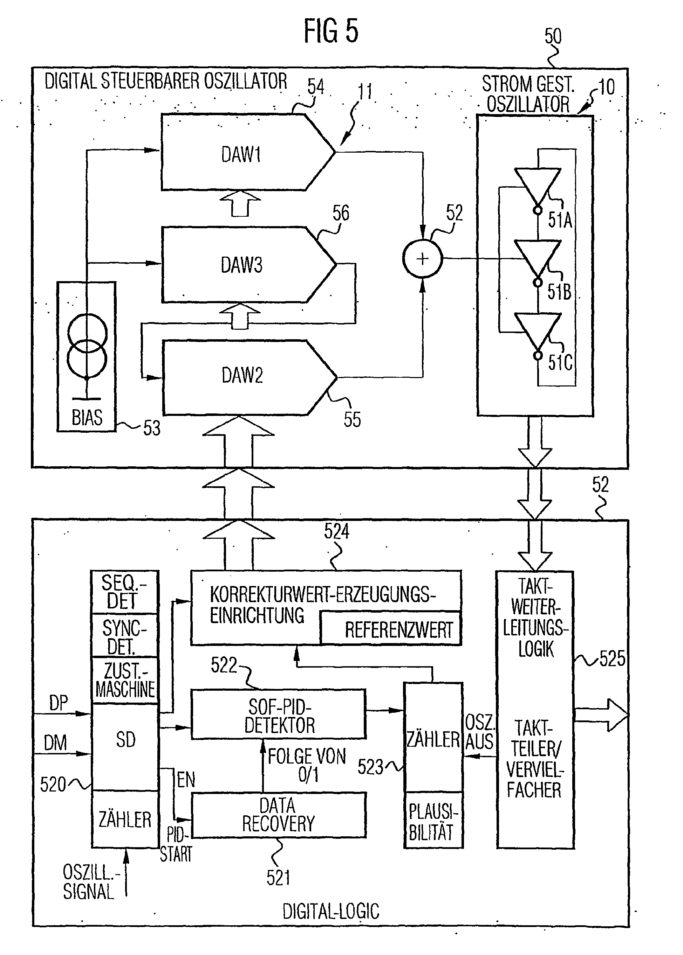

Nachfolgend wird Bezug nehmend auf Fig. 5 ein bevorzugtes Ausführungsbeispiel der vorliegenden Erfindung im Blockdiagrammform dargestellt. Fig. 5 zeigt eine Taktregenerationsschaltung, die prinzipiell aus zwei Haupteinheiten besteht. Die eine ist der digital steuerbare Oszillator 50, der eine Oszillatorsteuerung 11 einerseits und den steuerbaren Oszillator 10 andererseits aufweist, der in Fig. 5 ein stromgesteuerter Oszillator ist.

Fig. 5 zeigt ferner eine Digitallogik 52, die die Grobabstimmungseinrichtung 13 und die Feinabstimmungseinrichtung 14 umfasst, wie es nachfolgend dargestellt wird.

Der stromgesteuerte Oszillator 10 ist bei dem in Fig. 5 gezeigten bevorzugten Ausführungsbeispiel ein stromgesteuerter Ringoszillator mit einer ungeraden Anzahl von in Kette geschalteten Invertern 51a, 51b, 51c, die von einem Stromsummenknoten 52 mit einem Betriebsstrom versorgt werden, über den eine Schwingfrequenz des stromgesteuerten Oszillators 10 einstellbar ist.

Die Oszillatorsteuerungseinrichtung 11 umfasst neben dem Stromsummenknoten 52 eine Versorgungsstromquelle bzw. Referenzstromquelle 53, die eine zentrale Referenz liefert (es ist typischerweise zusätzlich ein eigenes Bias vorhanden), einen ersten Digital-Analog-Wandler 54, einen zweiten Digital-Analog-Wandler 55 und einen dritten Digital-Analog-Wandler 56. Die Digital-Analog-Wandler 54, 55 und 56 von Fig. 5 sind ausgebildet, um ausgangsseitig einen Strom zu liefern, der ein Bruchteil des eingangsseitig zugeführten Versorgungsstroms ist, wobei die Auswahl des Bruchteils über die dem Digital-Analog-Wandler über einen Digitaleingang zugeführte binäre Zahl erfolgt. Vorzugsweise werden binär-gewichtete Schaltungen 54, 55 und 56 bevorzugt. Beispielsweise liefert der DAW 1 (54) den Wert des Versorgungsstroms 53 an seinem Ausgang zum Stromsummationsknoten 52, wenn alle Bits der demselben zugeführten binären Zahl gesetzt sind. Ist dagegen nur das MSB des DAW 1 (54) gesetzt, während alle Bits mit niedriger Wertigkeit gleich 0 sind, so liefert der DAW 1 ausgangsseitig die Hälfte des von der Quelle 53 gelieferten Stroms zum Stromsummationsknoten. Erfindungsgemäß werden 9-Bit-DAWs bevorzugt, obgleich in der Ausführungsform auch DAWs mit höherer bzw. niedrigerer Breite eingesetzt werden können.

Wie es aus Fig. 5 ersichtlich ist, wird der DAW 1 54 direkt von der Stromversorgung 53 versorgt. Er kann daher ausgangsseitig den maximalen Strombetrag liefern. Der DAW 1 wird bei einem bevorzugten Ausführungsbeispiel der vorliegenden Erfindung durch die Grobabstimmung und die Feinabstimmung eingestellt. Insbesondere werden die höherwertigen Bits des DAW 1 durch die Grobabstimmung eingestellt, während die niederwertigen Bits des DAW 1 durch die Feinabstimmung eingestellt werden. Der DAW 2 55 wird zur Frequenzverfolgung eingesetzt. Sein Versorgungsstrom und damit der von ihm maximal zum Stromsummationsknoten 52-lieferbare Oszillatorsteuerstrom ist durch den DAW 3 56 steuerbar. Wird der DAW 3 56 mit einem Binärwert, in dem alle Bits gesetzt sind, angesteuert, so ist der Ausgabestrom des DAW 3 56 gleich dem Versorgungsstrom 53, was unmittelbar dazu führt, dass der DAW 2, wenn er ebenfalls mit lauter Einsen beaufschlagt wird, denselben Strom zum Summationsknoten 52 liefern kann. Erfindungsgemäß wird es jedoch bevorzugt, den DAW 3 mit einer Binärzahl zu beaufschlagen, die kleiner als die maximal beaufschlagbare Binärzahl ist, um den Maximalstrom, der durch den DAW 2 55 zum Stromsummationsknoten 52 geliefert wird, zu verringern. Dieser verringerte Maximalstrom ist dann aufgrund der Tatsache, dass der DAW 2 55 ebenfalls beispielsweise mit 9 Bits beaufschlagt werden kann, feiner unterteilbar, um eine Frequenzverfolgung, zu der der DAW 2 55 eingesetzt wird, mit einer feineren Genauigkeit durchführen zu können, wie sie durch das LSB des DAW 1 bestimmt ist. Allgemein gesagt ist die Granularität des Stroms, der durch den DAW.2 ausgegeben wird, umgekehrt proportional zu dem dem DAW 2 zugeführten Betriebsstrom. Je kleiner der Betriebsstrom ist, der dem DAW 2 zugeführt wird (eingestellt durch den DAW 3), um so feiner ist die Granularität im Frequenzverfolgungsmodus, der auf den Feinabstimmungsmodus folgt.

Der digital steuerbare Oszillator 11 umfasst somit eine Versorgungsquelle 53, den stromgesteuerten Ringoszillator 10 und die drei DAWs 54, 55 und 56. Die DAWs, die durch die Digitallogik 52 gesteuert werden, liefern den Steuerstrom zur Frequenzeinstellung des stromgesteuerten Oszillators ICO 10. Der Gesamtstrom für den ICO ist die Summe der Ströme, die von den beiden DAWs 54 und 55 geliefert werden. Die Bereiche der Digital-Analog-Wandler 1 und 2 sind vorzugsweise überlappend. Es wird bevorzugt, dass der maximale Ausgangsstrom des DAW 1 ein programmierbares Vielfaches (programmierbar durch den DAW 3) der maximalen Ausgabe des DAW 2 ist. Vorzugsweise wird ein Faktor 4 eingesetzt.

An dieser Stelle sei ferner darauf hingewiesen, dass während des Grobabstimmungsmodus und des Feinabstimmungsmodus der DAW 3 56 derart beaufschlagt wird, dass der Versorgungsstrom in dem DAW 2 um das programmierbare Vielfache kleiner ist als der Versorgungsstrom in dem DAW 1. Darüber hinaus wird bevorzugt, dass während der Grobabstimmung und der Feinabstimmung das MSB des DAW 2 gesetzt ist und/oder alle anderen Bits des DAW 2 nicht gesetzt sind. Der DAW 2 liefert damit die Hälfte des von ihm insgesamt möglichen maximalen Ausgangsstroms zum Stromsummationsknoten 52. Sind dann alle Bits des DAW durch den Grobabstimmungsmodus und den Feinabstimmungsmodus eingestellt, so kann durch zusätzliches Setzen von Bits des DAW 2, die eine kleinere Wertigkeit haben als das MSB desselben, der Strom vergrößert werden. Soll der Strom im Feinabstimmungsmodus dagegen verringert werden, so wird das MSB des DAW 2 rückgesetzt und es werden je nach Bedarf die Bits niedrigerer Ordnung gesetzt oder nicht gesetzt. Dadurch, dass während.des Grobabstimmungsmodus und des Feinabstimmungsmodus das MSB des DAW 2 gesetzt ist, wird sichergestellt, dass im Frequenzverfolgungsmodus, der auf den Feinabstimmungsmodus folgt, der Versorgungsstrom für den stromgesteuerten Oszillator sowohl erhöht als auch verringert werden kann.

Die Digitallogik 52 in Fig. 5 umfasst folgende grundsätzliche Funktionsblöcke. Zunächst umfasst die Schaltung einen Synchronisationsfelddetektor 520, der in Fig. 5 auch mit SD bezeichnet ist. Die Digitallogik umfasst ferner einen Datenwiederherstellungsblock 521, einen Rahmenstart-Paketidentifikationsdetektor (SOF-PID-Detektor) 522, einen Oszillatortaktzykluszähler 523, eine Digitaloszillatorsteuerlogik 524, die in Fig. 5 auch mit Korrekturwert-Erzeugungs-Einrichtung bezeichnet ist, und ferner einen Block 525, der mit Taktweiterleitungslogik und Takt-Teiler/Vervielfacher bezeichnet ist.

Der Synchronisationsfelddetektor 520 umfasst einen SEO-Detektor, einen Synchronisationsdetektor, eine Zustandsmaschine sowie einen eigenen Zähler. Der Block 520 ist mit den Differenz-Signalen Dp und Dm des USB-Busses verbunden. Der Block 520 ist wirksam, um Signale auf dem Bus abzuhören und damit den Busverkehr zu überwachen, um unter Verwendung des SEO-Detektors bestimmte Busbedingungen, wie z. B. das Vorliegen von "Single Ended Zero" zu erfassen. Im SEO-Modus sind sowohl Dp als auch Dm auf demselben Zustand, wie z. B. hoch. Nachdem Dp und Dm per Definition eigentlich Differenzsignale sind, ist der SE0-Zustand eigentlich ein verbotener Zustand, der keine aussagefähigen Nutzdaten enthält. Gemäß der USB-Spezifikation wird ein Zustand SE0 jedoch dann eingesetzt, wenn das Ende eines Pakets erreicht ist. Der SEO-Detektor erfasst somit das Ende eines vorausgehenden Pakets und damit auch den Beginn eines Synchronisationsfelds, das der Synchronisationsdetektor dann ansprechend auf den SEO-Detektor detektiert. Nachdem eine SEO-Bedingung im Block 520 erfasst worden ist, wird die Zustandsmaschine im Block 520 aktiviert, um auf den Empfang eines Synchronisationsmusters, wie es in Fig. 7a dargestellt ist, zu warten. Der Zähler im Block 520 misst die Länge des Synchronisationsmusters durch Zählen der Anzahl von Oszillatorperioden zwischen dem Beginn und dem Ende des Synchronisationsfeldes.

Der Data-Recovery-Block 521 wird durch den Block 520 über die mit EN bezeichnete Leitung aktiviert oder "enabled", nachdem der Block 520 ein gültiges Synchronisationsmuster empfangen hat. Die Data-Recovery-Einheit 521 wird wieder deaktiviert, wenn der Block 520 einen Zustand SE0 empfangen hat. Darüber hinaus wird das Meßergebnis vom Block 520 bezüglich der Länge des Synchronisationsfeldes dem Block 521 zugeführt, der diese Information dazu verwendet, um "Nullen" und "Einsen" aus dem seriellen USB-Datenstrom zu extrahieren, also den Datenstrom zu decodieren bzw. in dem Datenstrom enthaltene Informationen wiederzugewinnen. Immer wenn eine gültige "0" oder eine gültige "1" von dem Block 521 erkannt worden ist, wird diese an dem Ausgang des Blocks 521 signalisiert, derart, dass der Block 521 eine Folge von Nullen bzw. Einsen liefert.

Der Rahmenstart-Paketidentifikations-Detektor 521, der auch als SOF-Token-Detektor bezeichnet wird, untersucht den seriellen Datenstrom vom Block 521 und signalisiert dem Zähler 523, wenn er eine Rahmenstart-Paketidentifikationsnummer (SOF-PID) erfasst hat.

Der Oszillatortaktzykluszähler 523 zählt die Anzahl der DCO-Perioden zwischen dem Empfang aufeinanderfolgenden SOF-Tokens. Darüber hinaus umfasst der Zähler 523 eine Plausibilitätsüberprüfungseinrichtung, die untersucht, ob SOF-Tokens verfehlt worden sind. Die Plausibilitätsüberprüfungseinrichtung ist ausgebildet, um einen groben Zählwert mit einem aktuellen Zählwert zu vergleichen. Übersteigt der aktuelle Zählwert den groben Zählwert um einen sehr hohen Betrag, so deutet dies darauf herfassten wenigstens eine SOF-PID zwischen zwei erfassten SOF-PIDs verfehlt worden ist.. In diesem Fall wird der Zähler 523 dahingehend gesteuert, dass dieser Zählwert nicht der Einrichtung 524 zur Verfügung gestellt wird, da dies zu einer starken Fehleinstellung des steuerbaren Oszillators führen würde. Statt dessen wird dieser Zählwert als nicht plausibel markiert und verworfen.

Die Korrekturwert-Erzeugungs-Einrichtung 524 führt die Frequenzabstimmung und Frequenzverfolgung durch. Nach einem Reset ist der Frequenzabstimmungsalgorithmus aktiv. Zunächst wird die Frequenz des Oszillators grob abgestimmt. Zur Grobabstimmung wird die Zyklusanzahl des Synchronisationsmusters verwendet, die durch den Block 520 gemessen worden ist. Die Grobabstimmung bestimmt die höchstwertigen Bits des DAW 1, wie es ausgeführt worden ist. Mit jedem Abstimmschritt werden die niederwertigen Bits nach und nach bestimmt. Nach einer bestimmten Anzahl C von Grobabstimmungsschritten, wobei bei einer Bitbreite des DAW 1 von 9 drei Schritte für die Grobabstimmung bevorzugt werden, startet der Feinabstimmungsalgorithmus aktiviert durch eine in Fig. 1 dargestellte Steuerungseinrichtung, die die Schrittfolge der Grobabstimmung, Feinabstimmung und Frequenzverfolgung prinzipiell steuert.

Wenn die Breite des DAW 1 D1 Bits beträgt, beträgt die Anzahl der Feinabstimmungsschritte D1 - C.

Wie es ausgeführt worden ist, findet nach der Feinabstimmung die Frequenzverfolgung statt. Wie beim Feinabstimmungsalgorithmus wird auch bei der Frequenzverfolgung der Zykluszählwert des Zählers 521 eingesetzt, um die Oszillatorfrequenz über den DAW 2 55 weiter einzustellen.

Nachfolgend wird auf Fig. 6 Bezug genommen, um die Funktionalität der Korrekturwert-Erzeugungs-Einrichtung 524 detaillierter darzustellen.

In einem ersten Schritt 60 wird das höchstwertige Bit des DAW 1 gleich 1 gesetzt, während die restlichen Bits auf 0 gesetzt werden. Das MSB des DAW 2 wird während der ganzen Grob- und Feinabstimmung ebenfalls gesetzt, während die restlichen Bits des DAW 2 gleich 0 sind. In einem Schritt 61 führt die Einrichtung 524 anhand der Eingabewerte des Blocks SD 520 für die Grobabstimmung oder des Zählers 523 für die Feinabstimmung einen Frequenzvergleich durch. Ist die Frequenz zu groß, wird das MSB des DAW 1 gleich 0 gesetzt. Ist die Frequenz dagegen zu klein, bleibt das MSB des DAW 1 auf 1. Dann ist die Einrichtung 524 wirksam, um in einem Schritt 62 nunmehr das MSB-1 des DAW 1 zu setzen, nachdem das MSB derart ist, wie es im Schritt 61 bestimmt worden ist.

In einem Schritt 63 ist die Einrichtung 524 wieder wirksam, um einen Frequenzvergleich durchzuführen. Ist die Frequenz zu groß, so wird das Bit MSB-1 des DAW 1 auf 0 zurückgesetzt. Ist die Frequenz dagegen zu klein, so bleibt das Bit MSB-1 des DAW 1 auf seinem gesetzten Wert, d. h. auf 1. Auf diese Art und Weise der sukzessiven iterativen Approximation wird fortgeschritten, bis eine entsprechende vorbestimmte Anzahl von Bits des DAW 1 gesetzt ist. Dann wird durch die Steuerung 15 von Fig. 1 die Korrekturwert-Erzeugungs-Einrichtung 524 aktiviert, um vom Grobabstimmungsmodus in den Feinabstimmungsmodus zu gehen und nunmehr nicht mehr aufgrund der Zählwerte des Blocks 520 sondern aufgrund der Zählwerte des Blocks 523 zu arbeiten, um im Feinabstimmungsmodus die restlichen Bits des DAW 1 nach und nach zu berechnen.

Wenn schließlich alle Bits des DAW 1 berechnet sind (64), wird in den Frequenzverfolgungsmodus (65) geschaltet, in dem die Bits des DAW 2 entsprechend eingestellt werden. Wird im letzten Schritt 64 des Feinabstimmungsmodus festgestellt, dass die Frequenz zu klein war, so deutet dies darauf hin, dass das MSB des DAW 2, das zu Anfang im Schritt 60 auf 1 gesetzt wurde, zu Recht auf 1 ist. Wird dagegen im letzten Schritt 64 des Feinabstimmungsmodus festgestellt, dass die Frequenz zu groß ist, so wird das MSB des DAW 2 auf 0 gesetzt und die sukzessive Approximation mit dem MSB -1 des DAW 2 nach und nach durchgeführt. Je nach Ausführungsform kann zu bestimmten Zeitpunkten der DAW 3 umprogrammiert werden, um den Maximalausgabestrom und damit die Granularität des DAW 2 einzustellen bzw. an sich wechselnde Gegebenheiten anzupassen.

Abhängig von den Gegebenheiten kann das erfindungsgemäße Verfahren zum Extrahieren einer einem Datenstrom zugrundeliegenden Taktfrequenz in Hardware oder in Software implementiert werden. Die Implementation kann auf einem digitalen Speichermedium, insbesondere einer Diskette oder CD, mit elektronisch auslesbaren Steuersignalen erfolgen, die so mit einem programmierbaren Computersystem zusammenwirken können, dass das entsprechende Verfahren ausgeführt wird. Allgemein besteht die Erfindung somit auch in einem Computer-Programm-Produkt mit auf einem maschinenlesbaren Träger gespeichertem Programmcode zur Durchführung des erfindungsgemäßen Verfahrens, wenn das Computer-Programm-Produkt auf einem Rechner abläuft. In anderen Worten ausgedrückt kann die Erfindung somit als ein Computer-Programm mit einem Programmcode zur Durchführung des Verfahrens realisiert werden, wenn das Computer-Programm auf einem Computer abläuft.

Bezugszeichenliste

| 10 | steuerbarer Oszillator |
| 11 | Oszillatbrsteuerung |
| 12a | Grobabstimmungsleitung |
| 12b | Feinabstimmungsleitung |
| 13 | Grobabstimmungseinrichtung |
| 14 | Feinabstimmungseinrichtung |
| 15 | Gesamtsteuerung |
| 40 | Messen der Anzahl von Taktzyklen |
| 41 | Vergleichen mit einem Referenzwert |
| 42 | Frequenzverkleinern |
| 43 | Frequenzvergrößern |
| 44 | nächster Schritt |
| 50 | digital steuerbarer Oszillator |
| 51a | erster Inverter |
| 51b | zweiter Inverter |
| 51c | dritter Inverter |
| 52 | Stromsummationsknoten |
| 53 | Versorgungsquelle |
| 54 | Digital-Ahalog-Wandler 1 |
| 55 | Digital-Analog-Wandler 2 |
| 56 | Digital-Analog-Wandler 3 |
| 60 | MSB von DAW 1 setzen |
| 61 | Frequenzvergleich |
| 62 | MSB -1 von DAW 1 setzen |
| 63 | Frequenzvergleich |
| 64 | Frequenzvergleich im Feinabstimmungsmodus |
| 65 | Frequenzvergleich im Frequenzverfolgungsmodus |
| 72 | erster Rahmen |
| 73 | zweiter Rahmen |

| | |
|---|---|
| 74 | ein ms-Ticks |
| 75 | PID |
| 76 | Rahmenzahl |
| 77 | Fingerabdruck der Rahmenzahl |
| 80 | Vorrichtung zum Extrahieren |
| 90 | USB-Frontend |
| 91 | USB-Kern |
| 92 | Quarzoszillator |
| 93 | Quarzoszillatorbeschreibung |
| 94 | Taktverteilung |
| 95 | CPU |
| 96 | Speicher |
| 97 | Parallel-I/O-Schnittstelle |
| 130 | Einrichtung zum Erfassen |
| 131 | Einrichtung zum Zählen |
| 132 | Einrichtung zum Vergleichen |
| 140 | Einrichtung zum Erfassen |
| 141 | Einrichtung zum Zählen |
| 142 | Einrichtung zum Vergleichen |
| 520 | Synchronisationsdetektorblock |
| 521 | Datenwiederherstellungsblock |
| 522 | Rahmenstart-Paketidentifikations-Detektor |
| 523 | Feinabstimmungs-Zähler |
| 524 | Korrekturwert-Erzeugungs-Einrichtung |
| 525 | Taktweiterleitungslogik/Takt-Teiler/Vervielfacher |

**Patentansprüche**

1. Vorrichtung zum Extrahieren einer einem Datenstrom zugrundeliegenden Taktfrequenz, wobei der Datenstrom in regelmäßigen, mit einer relativen ersten Genauigkeit spezifizierten ersten zeitlichen Abständen ein erstes Datenmuster (SOF-PID) aufweist, und wobei der Datenstrom ferner ein zweites Datenmuster (SYNC-Feld) aufweist, das eine Mehrzahl von Taktperioden mit der Taktfrequenz oder einem Vielfachen der Taktfrequenz aufweist, wobei die Taktperioden mit einer zweiten relativen Genauigkeit spezifiziert sind, die kleiner als die erste relative Genauigkeit ist, mit folgenden Merkmalen:

einer Einrichtung (11) zum Steuern eines steuerbaren Oszillators zum Liefern eines Oszillatortakts mit einer Oszillatortaktfrequenz, wobei die Einrichtung (11) zum Steuern einen ersten Digital/Analog-Wandler (54) und einen zweiten Digital/Analog-Wandler (55) sowie einen Summierer (52) aufweist, der mit Ausgängen des ersten Digital/Analog-Wandlers (54) und des zweiten Digital/Analog-Wandlers (55) gekoppelt ist und ausgebildet ist, um ein Steuersignal (501) für den steuerbaren Oszillator zu liefern;
einer Grobabstimmungseinrichtung (13), die ausgebildet ist, um unter Verwendung des zweiten Datenmusters und einer Anzahl von Taktperioden des Oszillators die Einrichtung zum Steuern des Oszillators anzusteuern, um dessen Oszillatortaktfrequenz zu verringern, oder um die Oszillatortaktfrequenz zu erhöhen (132); und
einer Feinabstimmungseinrichtung (14), die wirksam ist, nachdem die Grobabstimmungseinrichtung wirksam war, und die ausgebildet ist,um unter Verwendung eines ersten Datenmusters und eines zeitlich folgenden ersten Datenmusters und einer Anzahl von Taktperioden des Oszillators zwischen dem ersten Datenmuster und dem zeitlich folgenden ersten Datenmuster die Einrichtung (11) zum Steuern des Oszillators anzusteuern, um dessen Oszillatortaktfrequenz zu verringern, oder um dessen Oszillatortaktfrequenz zu erhöhen (142),
wodurch eine Oszillatortaktfrequenz mit der relativen zweiten Genauigkeit erhalten wird, die gleich der dem Datenstrom zugrundeliegenden Taktfrequenz oder gleich einem Vielfachen oder einem Bruchteil der dem Datenstrom zugrundeliegenden Taktfrequenz ist,
wobei die Grobabstimmungseinrichtung und die Feinabstimmungseinrichtung wirksam sind, um Bits des ersten Digital/Analog-Wandlers (54) einzustellen;
einer Frequenzverfolgungseinrichtung (524), die ausgebildet ist, um nach einer Grobabstimmung durch die Grobabstimmungseinrichtung und nach einer Feinabstimmung durch die Feinabstimmungseinrichtung wirksam zu sein, und um Bits des zweiten Digital/Analog-Wandlers (54) einzustellen.

**2.** Vorrichtung nach Anspruch 1, bei der die Grobabstimmungseinrichtung ausgebildet ist,
um einen Beginn und ein Ende des zweiten Datenmusters zu detektieren (130),
um eine Anzahl von Taktperioden des Oszillators in einer Zeitdauer von dem Beginn zu dem Ende des zweiten Datenmusters zu zählen (131), und
um in dem Fall, in dem die gezählte Anzahl größer als ein Referenzwert ist, die Einrichtung zum Steuern des Oszillators anzusteuern, um dessen Oszillatortaktfrequenz zu verringern, oder um in dem Fall, in dem die gezählte Anzahl kleiner als der Referenzwert ist, die Einrichtung zum Steuern des Oszillators anzusteuern, um die Oszillatortaktfrequenz zu erhöhen (132).

**3.** Vorrichtung nach Anspruch 1 oder 2, bei der die Feinabstimmungseinrichtung ausgebildet ist,
um ein erstes Datenmuster und ein zeitlich folgendes erstes Datenmuster zu detektieren (140),
um eine Anzahl von Taktperioden des Oszillators zwischen dem ersten Datenmuster und dem zeitlich folgenden ersten Datenmuster zu zählen (141), und
um in dem Fall, in dem die gezählte Anzahl größer als ein Referenzwert ist, die Einrichtung (11) zum Steuern des Oszillators anzusteuern, um dessen Oszillatortaktfrequenz zu verringern, oder um in dem Fall, in dem die gezählte Anzahl kleiner als der Referenzwert ist, die Einrichtung (11) zum Steuern des Oszillators anzusteuern, um dessen Oszillatortaktfrequenz zu erhöhen (142)

**4.** Vorrichtung nach einem der vorhergehenden Ansprüche,
bei der der Datenstrom in Rahmen aufgeteilt ist, wobei jeder Rahmen eine Mehrzahl von Paketen aufweist, wobei ein erstes Paket in einem Rahmen eine Rahmenstartidentifikation (SOF-PID) aufweist, und wobei jedes Paket ein Synchronisationsfeld aufweist, wobei die Rahmenstartidentifikation als erstes Datenmuster verwendet wird, und wobei das Synchronisationsfeld als zweites Datenmuster verwendet wird.

**5.** Vorrichtung nach einem der vorhergehenden Ansprüche,
bei der das zweite Datenmuster zumindest zwei aufeinanderfolgende Null-Eins-Bitsequenzen aufweist.

**6.** Vorrichtung nach einem der vorhergehenden Ansprüche,
bei der die Grobabstimmungseinrichtung ausgebildet ist, um ein Signalmuster (SE0) in dem Datenstrom zu erfassen, das keine Nutzinformationen trägt, das sich von allen möglichen Datenmustern, die Nutzinformationen tragen, unterscheidet, und das dem zweiten Datenmuster in dem Datenstrom unmittelbar vorausgeht, wobei die Grobabstimmungseinrichtung ferner ausgebildet ist, um bei einer Erfassung des Signalmusters (SE0) einen dem Signalmuster folgenden Signalwechsel als Beginn des zweiten Datenmusters zu interpretieren.

**7.** Vorrichtung nach einem der Ansprüche 1 bis 5,
bei der das zweite Datenmuster eine vorbekannte Flankenfolge umfasst, wobei die Grobabstimmungseinrichtung ausgebildet ist, um Flankenwechsel nach einem Beginn des zweiten Datenmusters mitzuverfolgen, um das Ende des zweiten Datenmusters zu erfassen, wenn eine vorbestimmte Anzahl von Flankenwechseln abgelaufen ist.

**8.** Vorrichtung nach Anspruch 6, bei der der Datenstrom als differentielles Signal mit einem positiven Untersignal (Dp) und einem negativen Untersignal (Dm) vorliegt, wobei das Signalmuster derart gestaltet ist, dass beide Untersignale denselben Wert haben.

**9.** Vorrichtung nach einem der vorhergehenden Ansprüche,
bei der die Feinabstimmungseinrichtung folgende Merkmale aufweist:

eine Datenwiedergewinnungsschaltung (521), die ausgebildet ist, um von der Grobabstimmungseinrichtung (520) an einem Ende des zweiten Datenmusters aktiviert zu werden, um auf das zweite Datenmuster folgende Daten aus dem Datenstrom zu extrahieren.

**10.** Vorrichtung nach Anspruch 9, bei der die Feinabstimmungseinrichtung folgende Merkmale aufweist:

eine Datenuntersuchungseinrichtung (522) zum Untersuchen der von der Datenwiedergewinnungsschaltung (521) extrahierten Daten, um ein erstes Datenmuster zu detektieren, wenn untersuchte Daten gleich einem vorbestimmten Datenmuster sind.

**11.** Vorrichtung nach Anspruch 10, bei der das vorbestimmte Datenmuster eine spezielle vordefinierte Bitsequenz ist.

12. Vorrichtung nach Anspruch 11, bei der die spezielle vorbestimmte Bitsequenz eine Rahmenstart-Paketidentifikationsnummer ist.

13. Vorrichtung nach einem der vorhergehenden Ansprüche, bei der die Feinabstimmungseinrichtung einen Zähler (523) aufweist, der abhängig von einer Detektion eines ersten Datenmusters gestartet wird und abhängig von einer Detektion eines zeitlich folgenden ersten Datenmusters gestoppt wird.

14. Vorrichtung nach einem der vorhergehenden Ansprüche, bei der die Feinabstimmungseinrichtung eine Plausibilitätsüberprüfungseinrichtung aufweist, die ausgebildet ist, um eine gezählte Anzahl von Taktperioden des Oszillators dahingehend zu überprüfen, ob der Wert kleiner als eine obere Schwelle und damit plausibel ist, wobei im Falle einer festgestellten Nicht-Plausibilität der erhaltene Zählwert nicht für eine Feinabstimmung verwendet wird.

15. Vorrichtung nach einem der vorhergehenden Ansprüche, bei der der steuerbare Oszillator zusammen mit der Grobabstimmungseinrichtung und der Feinabstimmungseinrichtung auf einem Chip integriert ist.

16. Vorrichtung nach einem der vorhergehenden Ansprüche, bei der steuerbare Oszillator eine ungerade Anzahl von Invertern (51a, 51b, 51c) aufweist, die in einem Ring geschaltet sind.

17. Vorrichtung nach einem der vorhergehenden Ansprüche, bei der der steuerbare Oszillator (10) stromgesteuert ist.

18. Vorrichtung nach einem der vorhergehenden Ansprüche, bei der die Grobabstimmungseinrichtung ausgebildet ist, um iterativ zu arbeiten, und ferner ausgebildet ist, um in einem Iterationsschritt nach einer Frequenzverringerung oder Frequenzerhöhung erneut einen Beginn und ein Ende des zweiten Datenmusters zu detektieren, die Anzahl von Taktperioden zu zählen und den Oszillator anzusteuern.

19. Vorrichtung nach Anspruch 18, bei der die Grobabstimmungseinrichtung ausgebildet ist, um in einem ersten Iterationsschritt den steuerbaren Oszillator so anzusteuern, dass sich seine Frequenz um eine erste vorbestimmte Differenzfrequenz verändert, und um in einem weiteren Iterationsschritt den steuerbaren Oszillator zu anzusteuern, dass sich seine Frequenz um eine zweite vorbestimmte Differenzfrequenz verändert, wobei die zweite vorbestimmte Differenzfrequenz kleiner als die erste vorbestimmte Differenzfrequenz ist.

20. Vorrichtung nach einem der vorhergehenden Ansprüche, bei der die Feinabstimmungseinrichtung ausgebildet ist, um iterativ zu arbeiten, und ferner ausgebildet ist, um in einem weiteren Iterationsschritt nach einer Frequenzverringerung oder Frequenzerhöhung erneut ein Beginn und ein Ende des zweiten Datenmusters zu detektieren, die Anzahl von Taktperioden zu zählen und den Oszillator anzusteuern.

21. Vorrichtung nach einem der vorhergehenden Ansprüche, bei der die Feinabstimmungseinrichtung ausgebildet ist, um in einem ersten Iterationsschritt den steuerbaren Oszillator so anzusteuern, dass sich seine Frequenz um eine erste vorbestimmte Differenzfrequenz verändert, und um in einem weiteren Iterationsschritt den steuerbaren Oszillator so anzusteuern, dass sich seine Frequenz um eine zweite vorbestimmte Differenzfrequenz verändert, wobei die zweite vorbestimmte Differenzfrequenz kleiner als die erste vorbestimmte Differenzfrequenz ist.

22. Vorrichtung nach einem der Ansprüche 18 bis 21, bei der die Differenzfrequenz binär gewichtet ist und eine Differenzfrequenz immer halb so groß wie eine vorausgehende Differenzfrequenz ist.

23. Vorrichtung nach einem der vorhergehenden Ansprüche, bei der der erste Digital-Analog-Wandler (54) eingangsseitig mit einer binären Zahl einer Breite von n Bits beaufschlagbar ist, mit einer elektrischen Eingangsgröße (53) versorgbar ist und
wobei ein Betrag eines Ausgangssignals des ersten Digital/Analog-Wandlers gleich einem Verhältnis ist, das durch die binäre Zahl und die elektrische Eingangsgröße festgelegt ist.

24. Vorrichtung nach Anspruch 23, bei der die Grobabstimmungseinrichtung (524) ausgebildet ist, um iterativ und ausgehend von einem höchstwertigen Bit eine vorbestimmte Anzahl von dem höchstwertigen Bit folgenden niederwertigen Bits des ersten Digital/Analog-Wandlers (54) zu bestimmen, wobei die vorbestimmte Anzahl kleiner als n ist.

25. Vorrichtung nach Anspruch 24, bei der die Feinabstimmungseinrichtung ausgebildet ist, um iterativ und ausgehend von einem Bit, dessen Wertigkeit kleiner ist als ein durch die Grobabstimmungseinrichtung bestimmtes niederstwertiges Bit, restliche Bits des ersten Digital/Analog-Wandlers (54) zu bestimmen.

26. Vorrichtung nach einem der Ansprüche 23 bis 25,

bei der der zweite Digital-Analog-Wandler (55) durch eine elektrische Eingangsgröße versorgbar ist, die kleiner als die elektrische Eingangsgröße ist, mit der der erste Digital-Analog-Wandler (54) versorgt wird,

wobei ein höchstwertiges Bit des zweiten Digital-Analog-Wandlers (55) während eines Bestimmens von Bits des einen Digital-Analog-Wandlers (54) durch die Grobabstimmungseinrichtung und die Feinabstimmungseinrichtung gesetzt ist.

27. Vorrichtung nach Anspruch 26, bei der die Oszillatorsteuerungseinrichtung (11) einen dritten Digital-Analog-Wandler (56) aufweist, der ausgebildet ist, um die elektrische Eingangsgröße für den zweiten Digital-Analog-Wandler (55) zu liefern, wobei der dritte Digital-Analog-Wandler mit derselben elektrischen Eingangsgröße beaufschlagbar ist, mit der der erste Digital-Analog-Wandler (54) beaufschlagbar ist, und

wobei der dritte Digital-Analog-Wandler mit einer binären Zahl eingangsseitig belegbar ist, die bewirkt, dass die elektrische Eingangsgröße für den zweiten Digital-Analog-Wandler kleiner als die elektrische Eingangsgröße für den ersten Digital-Analog-Wandler ist.

28. Vorrichtung nach Anspruch 27,

bei der die Oszillatorsteuerungseinrichtung (11) ferner eine eigene Versorgungsquelle (53) zum Liefern der elektrischen Eingangsgröße für den ersten Digital-Analog-Wandler (54) und den dritten Digital-Analog-Wandler (56) aufweist.

29. Vorrichtung nach einem der Ansprüche 23 bis 28, bei der die elektrische Eingangsgröße ein Strom ist, und bei der die elektrische Ausgangsgröße ein Strom ist.

30. Vorrichtung nach einem der vorhergehenden Ansprüche,

bei der Datenstrom ein Datenstrom gemäß dem USB-Standard ist, in dem Taktfrequenzen von 1,5 MHz, 12 MHz und 480 MHz verwendbar sind.

31. Vorrichtung nach Anspruch 30, bei der die Oszillatortaktfrequenz auf eine Nennfrequenz von 96 MHz steuerbar ist, so dass die Oszillatortaktfrequenz das 64-fache von 1,5 MHz, das 8-fache von 12 MHz oder das 1/5-fache von 480 MHz beträgt, so dass für alle USB-Frequenzen dieselbe Nenn-Oszillatortaktfrequenz verwendbar ist.

32. Verfahren zum Extrahieren einer einem Datenstrom zugrundeliegenden Taktfrequenz, wobei der Datenstrom in regelmäßigen, mit einer relativen ersten Genauigkeit spezifizierten ersten zeitlichen Abständen ein erstes Datenmuster (SOF-PID) aufweist, und wobei der Datenstrom ferner ein zweites Datenmuster (SYNC-Feld) aufweist, das eine Mehrzahl von Taktperioden mit der Taktfrequenz oder einem Vielfachen der Taktfrequenz aufweist, wobei die Taktperioden mit einer zweiten relativen Genauigkeit spezifiziert sind, die kleiner als die erste relative Genauigkeit ist, mit folgenden Schritten:

Steuern eines steuerbaren Oszillators zum Liefern eines Oszillatortakts mit einer Oszillatortaktfrequenz unter Verwendung eines Grobabstimmungsschritts, eines Feinabstimmungsschritts, und eines Frequenzverfolgungsschritts, wobei das Steuern mittels eines ersten Digital/Analog-Wandlers (54) und eines zweiten Digital/Analog-Wandlers (55) sowie eines Summierers (52) durchgeführt wird, der mit Ausgängen des ersten Digital/Analog-Wandlers (54) und des zweiten Digital/Analog-Wandlers (55) gekoppelt ist und ausgebildet ist, um ein Steuersignal (501) für den steuerbaren Oszillator liefert,

wobei im Grobabstimmungsschritt unter Verwendung des zweiten Datenmusters und einer Anzahl von Taktperioden des Oszillators die Oszillatortaktfrequenz verringert oder erhöht wird; und

wobei im Feinabstimmungsschritt (14), der auf den Grobabstimmungsschritt folgt, unter Verwendung eines ersten Datenmusters und eines zeitlich folgenden ersten Datenmusters und einer Anzahl von Taktperioden des Oszillators zwischen dem ersten Datenmuster und dem zeitlich folgenden ersten Datenmuster die Oszillatortaktfrequenz verringert oder erhöht wird,

wodurch eine Oszillatortaktfrequenz mit der relativen zweiten Genauigkeit erhalten wird, die gleich der dem Datenstrom zugrundeliegenden Taktfrequenz oder gleich einem Vielfachen oder einem Bruchteil der dem Datenstrom zugrundeliegenden Taktfrequenz ist,

wobei durch den Grobabstimmungsschritt und den Feinabstimmungsschritt Bits des ersten Digital/Analog-Wandlers (54) eingestellt werden, und

wobei der Frequenzverfolgungsschritt nach dem Grobabstimmungsschritt und nach dem Feinabstimmungsschritt durchgeführt wird, und wobei im Frequenzverfolgungsschritt Bits des zweiten Digital/Analog-Wandlers (54) eingestellt werden.

**33.** Computer-Programm mit einem Programmcode zum Durchführen des Verfahrens zum Extrahieren gemäß Patentanspruch 32, wenn das Computer-Programm auf einem Computer abläuft.

**Claims**

**1.** A device for extracting a clock frequency underlying a data stream, wherein the data stream comprises a first data pattern (SOF-PID) at regular first temporal intervals specified with a relative first accuracy, and wherein the data stream further comprises a second data pattern (SYNC field) comprising a plurality of clock periods with the clock frequency or a multiple of the clock frequency,

wherein the clock periods are specified with a second relative accuracy smaller than the first relative accuracy, comprising:

means (11) for controlling a controllable oscillator for providing an oscillator clock with an oscillator clock frequency, wherein the means (11) for controlling comprises a first digital/analog converter (54) and a second digital/analog converter (55) as well as a summer (52), which is coupled to outputs of the first digital/analog converter (54) and the second digital/analaog converter (55), and implemented to provide a control signal (501) for the controllable oscillator;

a coarse-tuning means (13), implemented in order to control means for controlling the oscillator using the second data pattern and a number of clock periods of the oscillator in order to reduce its oscillator clock frequency or to increase (132) the oscillator clock frequency; and

a fine-tuning means (14) operable after the coarse-tuning means was operable and implemented in order to control means (11) for controlling the oscillator using a first data pattern and a temporally subsequent first data pattern and a number of clock periods of the oscillator between the first data pattern and the temporally following first data pattern in order to reduce its oscillator clock frequency or to increase its oscillator clock frequency (142), whereby an oscillator clock frequency is obtained with the relative second accuracy which is equal to the clock frequency underlying the data stream or equal to a multiple or a fraction of the clock frequency underlying the data stream,

wherein the coarse-tuning means and the fine-tuning means are operable to set bits of the first digital/analog converter (54);

a frequency-tracking means (524), which is implemented to be operable after coarse-tuning by the coarse-tuning means and after fine-tuning by the fine-tuning means, and to set bits of the second digital/analog converter (54).

**2.** The device according to claim 1, wherein the coarse-tuning means is implemented

to detect a beginning and an end of the second data pattern (130),

to count a number of clock periods of the oscillator in a time duration from the beginning to the end of the second data pattern (131), and

in the case in which the counted number is larger than a reference value, to control the control means for controlling the oscillator in order to reduce its oscillator clock frequency, or in the case in which the counted number is smaller than the reference value, to control the means for controlling the oscillator in order to increase the oscillator clock frequency (132).

**3.** The device according to claim 1 or 2, wherein fine-tuning means is implemented

to detect a first data pattern and a temporally following first data pattern (140),

to count a number of clock periods of the oscillator between the first data pattern and the temporally following first data pattern (141), and

in the case in which the counted number is larger than a reference value, to control means (11) for controlling the oscillator in order to reduce its oscillator clock frequency, or in the case in which the counted number is smaller than the reference value, to control means (11) for controlling the oscillator in order to increase its oscillator clock frequency (42).

**4.** The device according to one of the preceding claims,

wherein the data stream is divided into frames, wherein each frame comprises a plurality of packets, wherein a first packet in a frame comprises a start of frame identification (SOF-PID) and wherein each packet comprises a synchronization field wherein the start of frame identification is used as the first data pattern and wherein the synchronization field is used as the second data pattern.

5. The device according to one of the preceding claims,
   wherein the second data pattern comprises at least two consecutive zero-one bit sequences.

6. The device according to one of the preceding claims,
   wherein the coarse-tuning means is implemented to detect a signal pattern (SE0) in the data stream carrying no useful information which is different from all possible data patterns carrying useful information and which directly precedes the second data pattern in the data stream,
   wherein the coarse-tuning means is further implemented to interpret, in a detection of the signal pattern (SE0), a signal change following the signal pattern as the beginning of the second data pattern.

7. The device according to one of claims 1 to 5,
   wherein the second data pattern includes a pre-known edge sequence, wherein the coarse-tuning means is implemented in order to track edge changes after a beginning of the second data pattern in order to detect the end of the second data pattern when a predetermined number of edge changes has passed.

8. The device according to claim 6, wherein the data stream is present as a differential signal with a positive sub-signal (Dp) and a negative sub-signal (Dm), wherein the signal pattern is implemented such that both sub-signals have the same value.

9. The device according to one of the preceding claims,
   wherein the fine-tuning means further comprises:

   a data recovery circuit (521) implemented to be activated by the coarse-tuning means (520) at an end of the second data pattern in order to extract data following the second data pattern from the data stream.

10. The device according to claim 9, wherein the fine-tuning means further comprises:

    a data examination means (522) for examining the data extracted from the data recovery circuit (521) in order to detect a first data pattern when examined data are equal to a predetermined data pattern.

11. The device according to claim 10, wherein the predetermined data pattern is a special predefined bit sequence.

12. The device according to claim 11, wherein the special predetermined bit sequence is a start of frame packet identification number.

13. The device according to one of the preceding claims,
    wherein the fine-tuning means comprises a counter (523) which is started depending on a detection of a first data pattern and stopped depending on a detection of a temporally following first data pattern.

14. The device according to one of the preceding claims, wherein the fine-tuning means comprises a plausibility examination means which is implemented in order to examine a counted number of clock periods of the oscillator as to whether the value is smaller than an upper threshold and thus plausible, wherein in case of a determined non-plausibility the obtained count value is not used for a fine tuning.

15. The device according to one of the preceding claims, wherein the controllable oscillator is integrated on a chip together with the coarse-tuning means and the fine-tuning means.

16. The device according to one of the preceding claims, wherein the controllable oscillator comprises an odd number of inverters (51a, 51b, 51c) connected in a ring.

17. The device according to one of the preceding claims, wherein the controllable oscillator (10) is current-controlled.

18. The device according to one of the preceding claims,

wherein the coarse-tuning means is implemented in order to operate iteratively and is further implemented in order to detect again a beginning and an end of the second data pattern, to count the number of clock periods, and to control the oscillator in an iteration step after a frequency decrease or a frequency increase.

19. The device according to claim 18, wherein the coarse-tuning means is implemented in order to control the controllable oscillator in a first iteration step so that its frequency changes by a first predetermined differential frequency and in order to control the controllable oscillator in a further iteration step so that the frequency changes by a second predetermined differential frequency, wherein the second predetermined differential frequency is smaller than the first predetermined differential frequency.

20. The device according to one of the preceding claims, wherein the fine-tuning means is implemented in order to operate iteratively and is further implemented in order to detect again a beginning and an end of the second data pattern, to count the number of clock periods, and to control the oscillator in a further iteration step after the frequency decrease or the frequency increase.

21. The device according to one of the preceding claims, wherein the fine-tuning means is implemented in order to control the controllable oscillator in a first iteration step so that its frequency changes by a first predetermined differential frequency, and in order to control the controllable oscillator in a further iteration step so that its frequency changes by a second predetermined differential frequency, wherein the second predetermined differential frequency is smaller than the first predetermined differential frequency.

22. The device according to one of claims 18 to 21, wherein the differential frequency is binarily weighted and a differential frequency is always half the size of a preceding differential frequency.

23. The device according to one of the preceding claims,
wherein the first digital/analog converter (54) may be pulsed on the input side with a binary number of a width of n bits, may be supplied with an electric input quantity (53), and
wherein a magnitude of an output signal of the first digital/analog converter is equal to a ratio determined by the binary number and the electric input quantity.

24. The device according to claim 23, wherein the coarse-tuning means (524) is implemented in order to determine a predetermined number of low-order bits following the most significant bit of the first digital/analog converter (54) in an iterative way and based on the most significant bit, wherein the predetermined number is smaller than n.

25. The device according to claim 24, wherein the fine-tuning means is implemented in order to determine, iteratively and based on a bit, whose order is smaller than a least significant bit determined by the coarse-tuning means, remaining bits of the first digital/analog converter (54).

26. The device according to one of claims 23 to 25, wherein the second digital/analog converter (55) may be supplied with an electric input quantity smaller than the electric input quantity the first digital/analog converter (54) is supplied with,
wherein a most significant bit of the second digital/analog converter (55) is set during the determination of bits of the first digital/analog converter (54) by the coarse-tuning means and the fine-tuning means.

27. The device according to claim 26, wherein the oscillator control (11) comprises a third digital/analog converter (56) which is implemented in order to provide the electric input quantity for the second digital/analog converter (55), wherein the third digital/analog converter may be pulsed with the same electric input quantity with which the first digital/analog converter (54) may be pulsed, and wherein the third digital/analog converter may be occupied with a binary number on the input side which causes the electric input quantity for the second digital/analog converter to be smaller than the electric input quantity for the first digital/analog converter.

28. The device according to claim 27,
wherein the oscillator control means (11) further comprises its own supply source (53) for supplying the electric input quantity for the first digital/analog converter (54) and the third digital/analog converter (56).

29. The device according to one of claims 23 to 28, wherein the electric input quantity is a current and wherein the electric output quantity is a current.

**30.** The device according to one of the preceding claims,
wherein the data stream is a data stream according to the USB standard in which clock frequencies of 1.5 MHz, 12 MHz and 480 MHz may be used.

**31.** The device according to claim 30, wherein the oscillator clock frequency is controllable to a nominal frequency of 96 MHz, so that the oscillator clock frequency is the 64-fold of 1.5 MHz, the 8-fold of 12 MHz or the 1/5-fold of 480 MHz, so that the same nominal oscillator clock frequency may be used for all USB frequencies.

**32.** A method for extracting a clock frequency underlying a data stream, wherein the data stream comprises a first data pattern, (SOF-PID) in regular first temporal intervals specified with a relative first accuracy, and wherein the data stream further comprises a second data pattern (SYNC field) comprising a plurality of clock periods with the clock frequency or a multiple of the clock frequency,
wherein the clock periods are specified with a second relative accuracy which is smaller than the first relative accuracy, comprising the steps of:

controlling a controllable oscillator for providing an oscillator clock with an oscillator clock frequency using a coarse-tuning step, a fine-tuning step and a frequency-tracking step, wherein controlling is performed via a first digital/analog converter (54) and a second digital/analog converter (55) as well as a summer (52), which is coupled to outputs of the first digital/analog converter (54) and the second digital/analog converter (55), and implemented to provide a control signal (501) for the controllable oscillator,

wherein in the coarse-tuning step , the oscillator clock frequency is decreased or increased using the second data pattern and a number of clock periods of the oscillator; and
wherein in the fine-tuning step (14) following the coarse-tuning step, the oscillator clock frequency is decreased or increased using a first data pattern and a temporally following first data pattern and a number of clock periods of the oscillator between the first data pattern and the temporally following first data pattern,
whereby an oscillator clock frequency with the relative second accuracy is obtained which is equal to the clock frequency underlying the data stream or equal to a multiple or a fraction of the clock frequency underlying the data stream;
wherein bits of the first analog/digital converter (54) are set by the coarse-tuning step and the fine-tuning step, and wherein the frequency-tracking step is performed after the coarse-tuning step and the fine-tuning step, and wherein bits of the second analog/digital converter (55) are set in the frequency-tracking step.

**33.** A computer program having a program code for performing the method for extracting according to claim 32 when the computer program runs on a computer.

**Revendications**

**1.** Dispositif pour extraire une fréquence d'horloge à la base d'un flux de données, le flux de données présentant, à des intervalles de temps réguliers spécifiés avec une première précision relative, un premier modèle de données (SOF-PID), et le flux de données présentant, par ailleurs, un deuxième modèle de données (champ SYNC) présentant une pluralité de périodes de cycle d'horloge à la fréquence d'horloge ou un multiple de la fréquence d'horloge, les périodes de cycle d'horloge étant spécifiées avec une deuxième précision relative qui est inférieure à la première précision relative, aux caractéristiques suivantes :

un dispositif (11) destiné à régler un oscillateur réglable destiné à fournir un cycle d'horloge d'oscillateur avec une fréquence d'horloge d'oscillateur, le dispositif (11) destiné à commander un premier convertisseur numérique/analogique (54) et un deuxième convertisseur numérique/analogique (55) ainsi qu'un sommateur (52) qui est couplé à des sorties du premier convertisseur numérique/ analogique (54) et du deuxième convertisseur numérique/ analogique (55) et est réalisé de manière à fournir un signal de commande (501) pour l'oscillateur réglable ;
un dispositif de réglage approximatif (13) qui est réalisé de manière à activer, à l'aide du deuxième modèle de données et d'un nombre de périodes de cycle d'horloge de l'oscillateur, le dispositif destiné à régler l'oscillateur, pour réduire sa fréquence d'horloge d'oscillateur, ou pour augmenter la fréquence d'horloge d'oscillateur (132) ; et
un dispositif de réglage fin (14) qui est actif, après qu'était actif le dispositif de réglage approximatif, et qui est réalisé de manière à activer le dispositif (11) destiné à régler l'oscillateur à l'aide d'un premier modèle de données et d'un premier modèle de données successif dans le temps et d'un nombre de périodes de cycle d'horloge de l'oscillateur entre le premier modèle de données et le premier modèle de données successif dans le temps, pour réduire sa fréquence d'horloge d'oscillateur, ou pour augmenter sa fréquence d'horloge d'oscillateur (142), d'où est obtenue une fréquence d'horloge d'oscillateur avec la deuxième précision relative qui est égale à la fréquence d'horloge à la base du flux de données ou égale à un multiple ou une fraction de la fréquence d'horloge à la base du flux de données,

le dispositif de réglage approximatif et le dispositif de réglage fin étant actif pour régler des bits du premier convertisseur numérique/analogique (54) ;

un dispositif de suivi de fréquence (524), qui est réalisé de manière à être actif, après un réglage approximatif par le dispositif de réglage approximatif et après un réglage fin par le dispositif de réglage fin et à régler des bits du deuxième convertisseur numérique/analogique (54).

2. Dispositif selon la revendication 1, dans lequel le dispositif de réglage approximatif est réalisé de manière à détecter un début et une fin du deuxième modèle de données (130),

compter un nombre de périodes de cycle d'horloge de l'oscillateur dans un laps de temps de début à la fin du deuxième modèle de données (131), et

au cas où le nombre compté est supérieur à une valeur de référence, activer le dispositif destiné à régler l'oscillateur, pour réduire sa fréquence de cycle d'oscillateur, ou, au cas où le nombre compté est inférieur à une valeur de référence, activer le dispositif destiné à régler l'oscillateur, pour augmenter sa fréquence de cycle d'oscillateur (132).

3. Dispositif selon la revendication 1 ou 2, dans lequel le dispositif de réglage fin est réalisé de manière à détecter un premier modèle de données et un premier modèle de données successif dans le temps (140),

compter un nombre de périodes de cycle d'horloge de l'oscillateur entre le premier modèle de données et le premier modèle de données successif dans le temps (141), et

au cas où le nombre compté est supérieur à une valeur de référence, activer le dispositif (11) destiné à régler l'oscillateur, pour diminuer sa fréquence d'horloge d'oscillateur ou, au cas où le nombre compté est inférieur à une valeur de référence, activer le dispositif (11) destiné à régler l'oscillateur, pour augmenter sa fréquence d'horloge d'oscillateur (142).

4. Dispositif selon l'une des revendications précédentes,

dans lequel le flux de données est divisé en trames, chaque trame présentant une pluralité de paquets, un premier paquet présentant, dans une trame, une identification de début de trame (SOF-PID), et chaque paquet présentant un champ de synchronisation, l'identification de début de trame étant utilisée comme premier modèle de données, et le champ de synchronisation étant utilisé comme deuxième modèle de données.

5. Dispositif selon l'une des revendications précédentes,

dans lequel le deuxième modèle de données présente au moins deux séquences de bits zéro-un successives.

6. Dispositif selon l'une des revendications précédentes,

dans lequel le dispositif de réglage approximatif est réalisé de manière à détecter dans le flux de données un modèle de signal (SEO) qui ne porte pas d'informations utiles, qui se distingue de tous les modèles de données possibles portant des informations utiles, et qui précède immédiatement le deuxième modèle de données dans le flux de données, le dispositif de réglage approximatif étant, par ailleurs, réalisé de manière à interpréter, lors d'une détection du modèle de signal (SEO), un changement de signal suivant le modèle de signal comme début du deuxième modèle de données.

7. Dispositif selon l'une des revendications 1 à 5,

dans lequel le deuxième modèle de données comporte une succession de flancs connue d'avance, le dispositif de réglage approximatif étant réalisé de manière à suivre le changement de flanc après le début du deuxième modèle de données, pour détecter la fin du deuxième modèle de données lorsqu'il s'est écoulé un nombre prédéterminé de changements de flanc.

8. Dispositif selon la revendication 6, dans lequel le flux de données est présent sous forme de signal différentiel avec un sous-signal positif (Dp) et un sous-signal négatif (Dm), le modèle de signal étant réalisé de sorte que les deux sous-signaux aient la même valeur.

9. Dispositif selon l'une des revendications précédentes,

dans lequel le dispositif de réglage fin présente les caractéristiques suivantes :

un circuit de récupération de données (521) qui est réalisé de manière à être activé par le dispositif de réglage approximatif (520) à une fin du deuxième modèle de données, pour extraire du flux de données des données suivant le deuxième modèle de données.

10. Dispositif selon la revendication 9, dans lequel le dispositif de réglage fin présente les caractéristiques suivantes :

un dispositif d'examen de données (522) destiné à examiner les données extraites par le circuit de récupération de données (521), pour détecter un premier modèle de données lorsque des données examinées sont égales à un modèle de données prédéterminé.

11. Dispositif selon la revendication 10, dans lequel le modèle de données prédéterminé est une séquence de bits prédéfinie spéciale.

12. Dispositif selon la revendication 11, dans lequel la séquence de bits prédéfinie spéciale est un numéro d'identification de paquet de début de trame.

13. Dispositif selon l'une des revendications précédentes, dans lequel le dispositif de réglage fin présente un compteur (523) qui est démarré en fonction d'une détection d'un premier modèle de données et est arrêté en fonction d'une détection d'une premier modèle de données successif dans le temps.

14. Dispositif selon l'une des revendications précédentes, dans lequel le dispositif de réglage fin présente un dispositif de vérification de plausibilité qui est réalisé de manière à vérifier un nombre sélectionné de périodes de cycle d'horloge de l'oscillateur pour savoir si la valeur est inférieure à un seuil supérieur et est donc plausible, la valeur de comptage obtenue n'étant, dans le cas d'une non plausibilité constatée, pas utilisée pour un réglage fin.

15. Dispositif selon l'une des revendications précédentes, dans lequel l'oscillateur réglable est intégré sur une puce, ensemble avec le dispositif de réglage approximatif et le dispositif de réglage fin.

16. Dispositif selon l'une des revendications précédentes, dans lequel l'oscillateur réglable présente un nombre impair d'inverseurs (51a, 51b, 51c) qui sont connectés en forme d'anneau.

17. Dispositif selon l'une des revendications précédentes, dans lequel l'oscillateur réglable (10) est réglé par courant.

18. Dispositif selon l'une des revendications précédentes, dans lequel le dispositif de réglage approximatif est réalisé de manière à fonctionner de manière réitérative, et est, par ailleurs, réalisé de manière à détecter, dans une étape d'itération après une diminution de fréquence ou une augmentation de fréquence, à nouveau un début et une fin du deuxième modèle de données, à compter le nombre de périodes de cycle d'horloge et à activer l'oscillateur.

19. Dispositif selon la revendication 18, dans lequel le dispositif de réglage approximatif est réalisé de manière à activer, dans une première étape d'itération, l'oscillateur réglable de sorte que sa fréquence varie d'une première fréquence différentielle prédéterminée et à activer, dans une autre étape d'itération, l'oscillateur réglable de sorte que sa fréquence varie d'une deuxième fréquence différentielle prédéterminée, la deuxième fréquence différentielle prédéterminée étant inférieure à la première fréquence différentielle prédéterminée.

20. Dispositif selon l'une des revendications précédentes, dans lequel le dispositif de réglage fin est réalisé de manière à fonctionner de manière réitérative et est, par ailleurs, réalisé de manière à détecter à nouveau, dans une autre étape d'itération après une diminution de fréquence ou une augmentation de fréquence, un début et une fin du deuxième modèle de données, à compter le nombre de périodes de cycle d'horloge et à activer l'oscillateur.

21. Dispositif selon l'une des revendications précédentes, dans lequel le dispositif de réglage fin est réalisé de manière à activer, dans une première étape d'itération, l'oscillateur réglable de sorte que sa fréquence varie d'une première fréquence différentielle prédéterminée et à activer, dans une autre étape d'itération, l'oscillateur réglable de sorte que sa fréquence varie d'une deuxième fréquence différentielle prédéterminée, la deuxième fréquence différentielle prédéterminée étant inférieure à la première fréquence différentielle prédéterminée.

22. Dispositif selon l'une des revendications 18 à 21, dans lequel la fréquence différentielle est pondérée de manière binaire et une fréquence différentielle est toujours de la moitié d'une fréquence différentielle précédente.

23. Dispositif selon l'une des revendications précédentes, dans lequel le premier convertisseur numérique-analogique (54) peut être soumis, du côté de l'entrée, à un nombre binaire d'une largeur de n bits, peut être alimenté par une grandeur d'entrée électrique (53), et
une valeur d'un signal de sortie du premier convertisseur numérique-analogique est égale à un rapport qui est fixé par le nombre binaire et la grandeur d'entrée électrique.

24. Dispositif selon la revendication 23, dans lequel le dispositif de réglage approximatif (524) est réalisé de manière à déterminer, de manière réitérative et partant d'un bit à la valeur la plus élevée, un nombre prédéterminé de bits de valeur inférieure suivant le bit à la valeur la plus élevée du premier convertisseur numérique-analogique (54), le nombre prédéterminé étant inférieur à n.

25. Dispositif selon la revendication 24, dans lequel le dispositif de réglage fin est réalisé de manière à déterminer, de manière réitérative et partant d'un bit dont la valeur est inférieure à une valeur la plus basse déterminé par le dispositif de réglage approximatif, les bits restants du premier convertisseur numérique-analogique (54).

26. Dispositif selon l'une des revendications 23 à 25,
dans lequel le deuxième convertisseur numérique-analogique (55) peut être alimenté par une grandeur d'entrée électrique qui est plus petite que la grandeur d'entrée électrique par laquelle est alimenté le premier convertisseur numérique-analogique (54),
dans lequel un bit à la valeur la plus élevée du deuxième convertisseur numérique-analogique (55) est réglé, pendant une détermination de bits de l'un convertisseur numérique-analogique (54), par le dispositif de réglage approximatif et le dispositif de réglage fin.

27. Dispositif selon la revendication 26, dans lequel le dispositif de réglage d'oscillateur (11) présente un troisième convertisseur numérique-analogique (56) qui est réalisé de manière à fournir la grandeur d'entrée électrique pour le deuxième convertisseur numérique-analogique (55), le troisième convertisseur numérique-analogique pouvant être soumis à la même grandeur d'entrée électrique à laquelle peut être soumis le premier convertisseur numérique-analogique (54), et le troisième convertisseur numérique-analogique pouvant être occupé, du côté de l'entrée, par un nombre binaire qui fait que la grandeur d'entrée électrique pour le deuxième convertisseur numérique-analogique soit inférieure à la grandeur d'entrée électrique pour le premier convertisseur numérique-analogique.

28. Dispositif selon la revendication 27,
dans lequel le dispositif de réglage d'oscillateur (11) présente, par ailleurs, une source d'alimentation propre (53) destinée à fournir la grandeur d'entrée électrique pour le premier convertisseur numérique-analogique (54) et le troisième convertisseur numérique-analogique (56).

29. Dispositif selon l'une des revendications 23 à 28, dans lequel la grandeur d'entrée électrique est un courant, et dans lequel la grandeur de sortie électrique est un courant.

30. Dispositif selon l'une des revendications précédentes,
dans lequel le flux de données est un flux de données selon la norme USB dans lequel peuvent être utilisées des fréquences d'horloge de 1,5 MHz, 12 MHz et 480 MHz.

31. Dispositif selon la revendication 30, dans lequel la fréquence d'horloge d'oscillateur peut être réglée à une fréquence nominale de 96 MHz, de sorte que la fréquence d'horloge d'oscillateur soit de 64 fois 1,5 MHz, 8 fois 12 MHz ou 1/5 de 480 MHz, de sorte que la même fréquence d'horloge d'oscillateur nominale puisse être utilisée pour toutes les fréquences USB.

32. Procédé pour extraire une fréquence d'horloge à la base d'un flux de données, le flux de données présentant, à de premiers intervalles de temps réguliers spécifiés avec une première précision relative, un premier modèle de données (SOF-PID), et le flux de données présentant, par ailleurs, un deuxième modèle de données (Champ SYNC) présentant une pluralité de périodes de cycle d'horloge à la fréquence d'horloge ou un multiple de la fréquence d'horloge, les périodes de cycle d'horloge étant spécifiées avec une deuxième précision relative qui est inférieure à la première précision relative, aux étapes suivantes consistant à :

régler un oscillateur réglable destiné à fournir un cycle d'horloge d'oscillateur avec une fréquence de cycle d'horloge d'oscillateur à l'aide d'une étape de réglage approximatif, d'une étape de réglage fin, et d'une étape de suivi de fréquence, le réglage étant effectué au moyen d'un premier convertisseur numérique-analogique (54) et d'un deuxième convertisseur numérique-analogique (55) ainsi que d'un sommateur (52) qui est couplé aux sorties du premier convertisseur numérique-analogique (54) et du deuxième convertisseur numérique-analogique (55) et est réalisé de manière à fournir un signal de commande (501) pour l'oscillateur réglable, la fréquence d'horloge d'oscillateur étant diminuée ou augmentée, à l'étape de réglage approximatif, à l'aide du deuxième modèle de données et d'un nombre de périodes de cycle d'horloge de l'oscillateur; et la fréquence d'horloge d'oscillateur étant diminuée ou augmentée, à l'étape de réglage fin (14) qui suit l'étape de réglage approximatif, à l'aide d'un premier modèle de données et d'un premier modèle de données et d'un nombre de périodes de cycle d'horloge de l'oscillateur entre le premier modèle de données et le premier modèle de données, d'où est obtenue une fréquence d'horloge d'oscillateur avec la deuxième précision relative qui est égale à la fréquence d'horloge à la base du flux de données ou égale à un multiple ou une fraction de la fréquence d'horloge à la base du flux de données, par l'étape de réglage approximatif et l'étape de réglage fin étant réglés des bits du premier convertisseur numérique/analogique (54), et l'étape de suivi de fréquence étant réalisée après l'étape de réglage approximatif et après l'étape de réglage fin, et à l'étape de suivi de fréquence étant réglés des bits du deuxième convertisseur numérique/analogique (54).

33. Programme d'ordinateur avec un code de programme pour réaliser le procédé pour extraire selon la revendication 32 lorsque le programme d'ordinateur est exécuté sur un ordinateur.

EP 1 576 761 B1

## FIG 1

# FIG 2

## (GROBABSTIMMUNGSEINRICHTUNG)

DATEN-
STROM →

ERFASSEN VON
BEGINN UND ENDE
DES 2. DATEN -
MUSTERS ⟩~130

↓

ZÄHLEN DER
OSZILLATORPERIODEN
ZWISCHEN BEGINN
UND ENDE ⟩~131 ← OSZILLATORSIGNAL

↓

VERGLEICHEN MIT
REFERENZWERT UND
ERZEUGEN DES
KORREKTURSIGNALS ⟩~132 → ZUR OSZILLATOR-
STEUERUNG

# FIG 3

## (FEINABSTIMMUNGSEINRICHTUNG)
## (FREQUENZVERFOLGUNGSEINRICHTUNG)

DATEN-
STROM →

| ERFASSEN EINES ERSTEN DATENMUSTERS UND EINES ZEITLICH FOLGENDEN 1. DATENMUSTERS | ⟿ 140 |

↓

| ZÄHLEN DER OSZILLATORPERIODEN ZWISCHEN DEN ZWEI ERSTEN DATENMUSTERN | ⟿ 141 |

← OSZILLATORSIGNAL

↓

| VERGLEICHEN MIT REFERENZWERT UND ERZEUGEN DES KORREKTURSIGNALS | ⟿ 142 |

→ ZUR OSZILLATOR-STEUERUNG

EP 1 576 761 B1

FIG 4

MESSEN DER ANZAHL
VON TAKTZYKLEN — 40

VERGLEICHEN MIT
REFERENZWERT — 41

GRÖSSER ALS
REFERENZWERT

KLEINER ALS
REFERENZWERT

NÄCHSTER
SCHRITT — 44

42 — FREQUENZ
VERKLEINERN

FREQUENZ
VERGRÖSSERN — 43

27

## FIG 5

EP 1 576 761 B1

# FIG 6

```
┌──────────────────────────┬──────────────────────────┐
│ MSB VON DAW1=1,          │ MSB VON DAW2=1           │
│ RESTLICHE BITS=0         │ RESTLICHE BITS=0         │──60
└──────────────────────────┴──────────────────────────┘
                          │
                          ▼
    ┌────────────────────┬──────────────────────┐
61──│ FREQUENZVERGLEICH  │ FREQU. ZU GROSS      │──►MSB=0
    │                    ├──────────────────────┤
    │                    │ FREQU. ZU KLEIN      │──►MSB=1
    └────────────────────┴──────────────────────┘
                          │
                          ▼
    ┌───────────────────────────────────────────┐
    │ MSB-1 VON DAW1=1,                         │
    │ RESTLICHE BITS=0                          │──62
    └───────────────────────────────────────────┘
                          │
                          ▼
    ┌────────────────────┬──────────────────────┐
63──│ FREQUENZVERGLEICH  │ FREQU. ZU GROSS      │──►MSB-1=0
    │                    ├──────────────────────┤
    │                    │ FREQU. ZU KLEIN      │──►MSB-1=1
    └────────────────────┴──────────────────────┘
                          ┊
```

- - - - - - - - - - - - - - - - - - - - - - - - -   GROB
                                                     ─────
                                                     FEIN

```
    ┌────────────────────┬──────────────────────┐
64──│ FREQUENZVERGLEICH  │ FREQU. ZU GROSS      │──►LSB=0
    │                    ├──────────────────────┤
    │                    │ FREQU. ZU KLEIN      │──►LSB=1
    └────────────────────┴──────────────────────┘
                          │
```

- - - - - - - - - - - - - - - - - - - - - - - - -
                                          FREQUENZVERFOLGUNG

```
    ┌───────────────────────────────────────────┐
65──│ FREQUENZVERGLEICH: MSB VON DAW2=0/1        │
    │ -BEREICHSEINSTELLG. FÜR DAW2 NIT DAW3      │
    └───────────────────────────────────────────┘
```

## FIG 7A

SYNC PATTERN

IDLE

1  0  1  0  1  0  1  1

PID0 PID1

## FIG 7B

72          73

1 ms        1 ms       • • •

74          74  NUTZERDATEN  74

## FIG 7C

(LSb)                                                                    (MSb)

| PID$_0$ | PID$_1$ | PID$_2$ | PID$_3$ | $\overline{PID}_0$ | $\overline{PID}_1$ | $\overline{PID}_2$ | $\overline{PID}_3$ |
|---|---|---|---|---|---|---|---|

## FIG 7D

75          76          77
(lsb)                   (msb)

| FELD | PID | FRAMENUMBER | CRC5 |
|---|---|---|---|
| BITS | 8 | 11 | 5 |

# FIG 8

```
        94                    80
   ┌──────────┐         ┌──────────────┐              90
   │  TAKT-   │◄────────│ VORRICHTUNG  │              ┌──────────────┐
   │VERTEILUNG│         │    ZUM       │              │  ANALOGES    │  D+
   └──────────┘         │  EXTRAHIEREN │              │    USB       │◄──►
        │            95 └──────────────┘              │              │
        ▼          ┌──────────┐                       │  FRONTEND    │  D-
   ┌──────────┐    │ USB-KERN │◄─────────────────────►│              │◄──►
   │   CPU    │◄──►│          │                       │ DIFFERENZ-   │
   └──────────┘    └──────────┘                       │   RX/TX      │
        │              │  91                          └──────────────┘
        ▼              │
   ┌──────────┐    ┌──────────────┐
   │ SPEICHER │    │ PARALLEL-I/O │──────────────────────────────────►
   └──────────┘    └──────────────┘
        96              97
```

# FIG 9

```
                            92
                        ┌────┐
                        │    │
                        └────┘
                            93
        94                  │
   ┌──────────┐         ┌──────────────┐              90
   │  TAKT-   │◄────────│QUARZOSZILLATOR│             ┌──────────────┐
   │VERTEILUNG│         │ -BESCHALTUNG │              │  ANALOGES    │  D+
   └──────────┘         └──────────────┘              │    USB       │◄──►
        │            95      │                        │              │
        ▼                    ▼                        │  FRONTEND    │  D-
   ┌──────────┐    ┌──────────┐                       │              │◄──►
   │   CPU    │◄──►│ USB-KERN │◄─────────────────────►│ DIFFERENZ-   │
   └──────────┘    └──────────┘                       │   RX/TX      │
        │              │  91                          └──────────────┘
        ▼              │
   ┌──────────┐    ┌──────────────┐
   │ SPEICHER │    │ PARALLEL-I/O │──────────────────────────────────►
   └──────────┘    └──────────────┘
        96              97
```